# EUROPEAN PATENT APPLICATION

(11) **EP 4 518 180 A1**
(43) Date of publication of application: **05.03.2025**
(21) Application number: 23810970.6
(22) Date of filing: 19.05.2023
(51) Int. Cl.: H04B 7/06

(54) **CSI OBTAINING METHOD AND DEVICE**

(30) Priority: 27.05.2022 CN 202210590957
(71) Applicant: Huawei Technologies Co., Ltd., Shenzhen, Guangdong 518129 (CN)
(72) Inventor: XIAO, Houfei, Shenzhen, Guangdong 518129 (CN); DING, Rentian, Shenzhen, Guangdong 518129 (CN); SUN, Fanglin, Shenzhen, Guangdong 518129 (CN)
(74) Representative: Isarpatent
(86) International application number: PCT/CN2023/095333
(87) International publication number: WO 2023/226899

(57) **Abstract**

This application provides a CSI obtaining method and an apparatus, and relates to the field of communication technologies, to improve stability of obtained CSI, and further improve sensing precision. The method includes: When a first node is in a sensing mode, the first node receives at least one first signal frame from a second node; the first node processes the at least one first signal frame based on a same AGC gain; and the first node obtains CSI based on at least one processed first signal frame. In this way, the first node may process different sensing packets based on a same AGC gain, to obtain CSI, so that impact of bottom-layer processing of the first node can be well suppressed, and the obtained CSI is more stable. In addition, when a target is sensed based on the CSI with high stability, sensing precision can be further improved. For example, a status of the target, for example, a static state and a moving state, can be better distinguished between each other.

## Description

This application claims priority to Chinese Patent Application No. 202210590957.0, filed with the China National Intellectual Property Administration on May 27, 2022 and entitled "CSI OBTAINING METHOD AND APPARATUS", which is incorporated herein by reference in its entirety.

### TECHNICAL FIELD

This application relates to the field of communication technologies, and in particular, to a CSI obtaining method and an apparatus.

### BACKGROUND

In a wireless communication process, a to-be-sensed target (for example, a human body) may interfere with a radio signal, and consequently a radio channel changes. Therefore, a wireless communication device may sense the target based on channel state information (channel state information, CSI), to meet application requirements of wireless sensing, such as human body presence detection, posture recognition, fall detection, and intrusion detection.

Currently, the wireless communication device may adjust gains of various components in a receive path through an automatic gain control (automatic gain control, AGC) component (or referred to as an AGC circuit, an AGC algorithm, an AGC module, or the like), and then process a signal corresponding to a sensing packet (namely, a packet for sensing the target) through the components on which gain adjustment is performed, to obtain the CSI. However, the wireless communication device may adjust the gains of the various components in the receive path through the AGC component based on power of a signal corresponding to each sensing packet, so as to process the sensing packet. In this way, obtained CSI fluctuates greatly, and precision is low when the CSI is used to sense the target.

### SUMMARY

This application provides a CSI obtaining method and an apparatus, to improve stability of obtained CSI, and further improve sensing precision.

To achieve the foregoing objective, the following technical solutions are used in this application.

According to a first aspect, this application provides a channel state information CSI obtaining method. The method may be performed by a first node, or may be performed by a component of a first node, for example, a processor, a chip, or a chip system of the first node, or may be implemented by a logical module or software that can implement all or some functions of the first node. In this application, an example in which the first node performs the method is used for description. The method includes: When the first node is in a sensing mode, the first node receives at least one first signal frame from a second node; the first node processes the at least one first signal frame based on a same automatic gain control AGC gain; and the first node obtains CSI based on at least one processed first signal frame.

According to the foregoing solution, the first node in the sensing mode may process different sensing packets based on a same AGC gain, so that impact of bottom-layer processing of the first node can be well suppressed, and obtained CSI is more stable and can more truly reflect a channel state of an air interface channel. In addition, when a target is sensed based on the CSI with high stability, sensing precision can be further improved. For example, statuses (for example, a moving state and a static state) of the target are better distinguished between each other, and a posture (for example, a gesture or a fall) is better recognized.

In a possible design, the method further includes: When the first node is in a non-sensing mode, the first node receives at least one second signal frame from the second node; and the first node processes the at least one second signal frame based on different AGC gains. According to this design, when normal service communication is performed between the first node and another node, the first node may process each service packet based on a corresponding AGC gain, so that power of a signal corresponding to each service packet may be constant or basically unchanged. In this way, communication performance during the service communication can be ensured.

In a possible design, the method further includes: When a preset condition is met, the first node updates a value of the used same AGC gain. The preset condition includes one or more of the following: preset duration; a quantity of first signal frames received by the first node meets a first threshold; a total quantity of first signal frames and second signal frames that are received by the first node meets a second threshold; and the first node determines that a probability that an error occurs when the first signal frame is parsed is greater than a preset probability. CSI obtaining may be affected by factors such as different temperatures and different environments (for example, a placement location of an object in a room). Therefore, according to this design, when the preset condition is met, the first node periodically updates the value of the same AGC gain, so that in different scenarios, a sensing packet can be processed based on an appropriate value of the AGC gain to obtain CSI, to further improve stability of the obtained CSI.

In a possible design, before the first node receives the at least one first signal frame from the second node, the method further includes: When the first node is in the sensing mode, the first node receives at least one third signal frame from the second node; and the first node processes the at least one third signal frame based on different AGC gains.

In a possible design, before the first node receives the at least one first signal frame from the second node, the method further includes: The first node sends a scheduling message to the second node, where the scheduling message indicates the second node to send the at least one first signal frame to the first node.

In a possible design, the value of the same AGC gain is determined based on values of the different AGC gains.

In a possible design, the value of the same AGC gain corresponds to the second node.

In a possible design, each of the at least one first signal frame includes a first field and a second field. That the first node processes the at least one first signal frame based on a same AGC gain includes: The first node processes at least one first field based on the same AGC gain, and the first node processes at least one second field based on the same AGC gain or different AGC gains, where CSI obtained based on the at least one first field is used by the first node to sense a target; or the first node processes at least one first field based on the same AGC gain or different AGC gains, and the first node processes at least one second field based on the same AGC gain, where CSI obtained based on the at least one second field is used by the first node to sense a target.

According to this design, for a field used for sensing the target, the first node may process the field based on a same AGC gain, and for a field not used for sensing the target, the first node may process the field based on a same AGC gain, or may process the field based on different AGC gains. This ensures high stability of obtained CSI, and improves flexibility of processing each field.

In a possible design, before the first node receives the at least one first signal frame from the second node, the method further includes: The first node receives a first message, where the first message is generated based on a first operation; and the first node enables the sensing mode in response to the first message. According to this design, a user may manually enable the sensing mode of the first node based on a requirement.

In a possible design, before the first node receives the at least one first signal frame from the second node, the method further includes: The first node receives a second message, where the second message is generated based on a second operation; and the first node determines the second node in response to the second message. According to this design, the user may select an appropriate device as the second node based on a requirement.

According to a second aspect, this application provides a CSI obtaining method. The method may be performed by a second node, or may be performed by a component of a second node, for example, a processor, a chip, or a chip system of the second node, or may be implemented by a logical module or software that can implement all or some functions of the second node. In this application, an example in which the second node performs the method is used for description. The method includes: The second node generates at least one first signal frame; and the second node sends the at least one first signal frame to a first node, where the at least one first signal frame is processed by the first node in a sensing mode based on a same AGC gain, to obtain CSI information.

In a possible design, the method further includes: The second node generates at least one second signal frame; and the second node sends the at least one second signal frame to the first node, where the at least one second signal frame is processed by the first node in a non-sensing mode based on different AGC gains.

In a possible design, a value of the same AGC gain is updated when a preset condition is met. The preset condition includes one or more of the following: preset duration; a quantity of first signal frames received by the first node meets a first threshold; a total quantity of first signal frames and second signal frames that are received by the first node meets a second threshold; and the first node determines that a probability that an error occurs when the first signal frame is parsed is greater than a preset probability.

In a possible design, before the second node sends the at least one first signal frame to the first node, the method further includes: The second node sends at least one third signal frame to the first node, where the at least one third signal frame is processed by the first node in the sensing mode based on different AGC gains.

In a possible design, before the second node sends the at least one first signal frame to the first node, the method further includes: The second node receives a scheduling message from the first node, where the scheduling message indicates the second node to send the at least one first signal frame to the first node.

In a possible design, the value of the same AGC gain is determined based on values of the different AGC gains.

In a possible design, the value of the same AGC gain corresponds to the second node.

In a possible design, each of the at least one first signal frame includes a first field and a second field, and that the at least one first signal frame is processed by the first node in a sensing mode based on a same AGC gain is specifically: at least one first field is processed by the first node in the sensing mode based on a same AGC gain, and at least one second field is processed by the first node in the sensing mode based on a same AGC gain or different AGC gains, where CSI obtained based on the at least one first field is used by the first node to sense a target; or at least one first field is processed by the first node in the sensing mode based on a same AGC gain or different AGC gains, and at least one second field is processed by the first node in the sensing mode based on a same AGC gain, where CSI obtained based on the at least one second field is used by the first node to sense a target.

According to a third aspect, this application provides a communication apparatus. The communication apparatus is configured to implement the method according to any one of the first aspect and the designs of the first aspect. The communication apparatus may be the first node in the first aspect, or an apparatus included in the first node, for example, a chip. The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In a possible design, the communication apparatus includes a communication module (or referred to as a communication unit) and a processing module (or referred to as a processing unit). The communication module is configured to receive at least one first signal frame from a second node when the communication apparatus is in a sensing mode. The processing module is configured to process the at least one first signal frame based on a same automatic gain control AGC gain. The processing module is further configured to obtain CSI based on at least one processed first signal frame.

In a possible design, the communication module is further configured to receive at least one second signal frame from the second node when the communication apparatus is in a non-sensing mode. The processing module is further configured to process the at least one second signal frame based on different AGC gains.

In a possible design, the processing module is further configured to update a value of the used same AGC gain when a preset condition is met. The preset condition includes one or more of the following: preset duration; a quantity of first signal frames received by the communication apparatus meets a first threshold; a total quantity of first signal frames and second signal frames that are received by the communication apparatus meets a second threshold; and the communication apparatus determines that a probability that an error occurs when the first signal frame is parsed is greater than a preset probability.

In a possible design, the communication module is further configured to receive at least one third signal frame from the second node when the communication apparatus is in the sensing mode. The processing module is further configured to process the at least one third signal frame based on different AGC gains.

In a possible design, the communication module is further configured to send a scheduling message to the second node, where the scheduling message indicates the second node to send the at least one first signal frame to the communication apparatus.

In a possible design, the value of the same AGC gain is determined based on values of the different AGC gains.

In a possible design, the value of the same AGC gain corresponds to the second node.

In a possible design, each of the at least one first signal frame includes a first field and a second field. The processing module is further configured to process at least one first field based on the same AGC gain, and process at least one second field based on the same AGC gain or different AGC gains, where CSI obtained based on the at least one first field is used by the communication apparatus to sense a target. Alternatively, the processing module is further configured to process at least one first field based on the same AGC gain or different AGC gains, and process at least one second field based on the same AGC gain, where CSI obtained based on the at least one second field is used by the communication apparatus to sense a target.

In a possible design, the communication module is further configured to receive a first message, where the first message is generated based on a first operation. The processing module is further configured to enable the sensing mode in response to the first message.

In a possible design, the communication module is further configured to receive a second message, where the second message is generated based on a second operation. The processing module is further configured to determine the second node in response to the second message.

According to a fourth aspect, this application provides a communication apparatus. The communication apparatus is configured to implement the method according to any one of the second aspect and the designs of the second aspect. The communication apparatus may be the second node in the second aspect, or an apparatus included in the second node, for example, a chip. The communication apparatus includes a corresponding module, unit, or means (means) for implementing the foregoing method. The module, unit, or means may be implemented by hardware, software, or hardware executing corresponding software. The hardware or the software includes one or more modules or units corresponding to the foregoing functions.

In a possible design, the communication apparatus includes a communication module (or referred to as a communication unit) and a processing module (or referred to as a processing unit). The processing module is configured to generate at least one first signal frame. The communication module is configured to send the at least one first signal frame to a first node, where the at least one first signal frame is processed by the first node in a sensing mode based on a same AGC gain, to obtain CSI information.

In a possible design, the processing module is further configured to generate at least one second signal frame. The communication module is further configured to send the at least one second signal frame to the first node, where the at least one second signal frame is processed by the first node in a non-sensing mode based on different AGC gains.

In a possible design, a value of the same AGC gain is updated when a preset condition is met. The preset condition includes one or more of the following: preset duration; a quantity of first signal frames received by the first node meets a first threshold; a total quantity of first signal frames and second signal frames that are received by the first node meets a second threshold; and the first node determines that a probability that an error occurs when the first signal frame is parsed is greater than a preset probability.

In a possible design, the communication module is further configured to send at least one third signal frame to the first node, where the at least one third signal frame is processed by the first node in the sensing mode based on different AGC gains.

In a possible design, the communication module is further configured to receive a scheduling message from the first node, where the scheduling message indicates the communication apparatus to send the at least one first signal frame to the first node.

In a possible design, the value of the same AGC gain is determined based on values of the different AGC gains.

In a possible design, the value of the same AGC gain corresponds to the communication apparatus.

In a possible design, each of the at least one first signal frame includes a first field and a second field, and that the at least one first signal frame is processed by the first node in a sensing mode based on a same AGC gain is specifically: at least one first field is processed by the first node in the sensing mode based on a same AGC gain, and at least one second field is processed by the first node in the sensing mode based on a same AGC gain or different AGC gains, where CSI obtained based on the at least one first field is used by the first node to sense a target; or at least one first field is processed by the first node in the sensing mode based on a same AGC gain or different AGC gains, and at least one second field is processed by the first node in the sensing mode based on a same AGC gain, where CSI obtained based on the at least one second field is used by the first node to sense a target.

According to a fifth aspect, this application provides a communication apparatus, including a processor and a communication interface. The communication interface is configured to communicate with a module outside the communication apparatus. The processor is configured to execute a computer program or instructions, so that the communication apparatus performs the method according to any one of the first aspect and the designs of the first aspect. The communication apparatus may be the first node in the first aspect, or an apparatus included in the first node, for example, a chip, so that the communication apparatus performs the method according to any one of the second aspect and the designs of the second aspect. The communication apparatus may be the second node in the second aspect, or an apparatus included in the second node, for example, a chip.

In a possible design, the communication apparatus includes a memory. The memory is configured to store necessary program instructions and necessary data. The memory may be coupled to the processor, or may be independent of the processor.

According to a sixth aspect, this application provides a computer-readable storage medium, including a computer program or instructions. When the computer program or the instructions are run on a communication apparatus, the communication apparatus is enabled to perform the method according to any one of the first aspect and the designs of the first aspect, or the communication apparatus is enabled to perform the method according to any one of the second aspect and the designs of the second aspect.

According to a seventh aspect, this application provides a computer program product, where the computer program product includes a computer program or instructions. When the computer program or the instructions are run on a computer, the computer is enabled to perform the method according to any one of the first aspect and the designs of the first aspect, or the computer is enabled to perform the method according to any one of the second aspect and the designs of the second aspect.

According to an eighth aspect, this application provides a chip, including a processing circuit and an input/output interface, where the processing circuit and the input/output interface are configured to implement the method provided in any design of the first aspect or the second aspect. The processing circuit is configured to perform a processing action in the corresponding method, and the input/output interface is configured to perform a receiving/sending action in the corresponding method.

According to a ninth aspect, this application provides a communication system, including the communication apparatus provided in any one of the third aspect or the designs of the third aspect, and the communication apparatus provided in any one of the fourth aspect or the designs of the fourth aspect.

It should be noted that, for technical effect brought by any one of the designs of the second aspect to the ninth aspect, refer to technical effect brought by a corresponding design of the first aspect. Details are not described herein again.

### BRIEF DESCRIPTION OF DRAWINGS

FIG. 1 is a diagram of a signal transmission path according to an embodiment of this application;
FIG. 2 is a diagram of a structure in which a wireless communication device processes a received packet according to an embodiment of this application;
FIG. 3 is a diagram of CSI simulation according to an embodiment of this application;
FIG. 4 is a diagram of an architecture of a communication system according to an embodiment of this application;
FIG. 5 is a diagram of a structure of a terminal device according to an embodiment of this application;
FIG. 6 is a diagram of a sensing scenario in a home environment according to an embodiment of this application;
FIG. 7 is a diagram of another sensing scenario in a home environment according to an embodiment of this application;
FIG. 8 is a schematic flowchart of a CSI obtaining method according to an embodiment of this application;
FIG. 9 is a diagram of enabling a sensing mode of a first node according to an embodiment of this application;
FIG. 10 is another diagram of enabling a sensing mode of a first node according to an embodiment of this application;
FIG. 11(1) to FIG. 11(3) are a diagram of a group of interfaces according to an embodiment of this application;
FIG. 12 is a diagram of a structure of a frame format according to an embodiment of this application;
FIG. 13 is another diagram of CSI simulation according to an embodiment of this application;
FIG. 14 is a schematic flowchart of another CSI obtaining method according to an embodiment of this application;
FIG. 15 is a diagram of another structure in which a wireless communication device processes a received packet according to an embodiment of this application;
FIG. 16 is a schematic flowchart of another CSI obtaining method according to an embodiment of this application;
FIG. 17A and FIG. 17B are a schematic flowchart of another CSI obtaining method according to an embodiment of this application;
FIG. 18 is a diagram of a structure of a communication apparatus according to an embodiment of this application; and
FIG. 19 is a diagram of a structure of another communication apparatus according to an embodiment of this application.

### DESCRIPTION OF EMBODIMENTS

The following describes the technical solutions in embodiments of this application in detail with reference to the accompanying drawings.

Terms "including", "having", and any other variant thereof mentioned in descriptions of this application are intended to cover a non-exclusive inclusion. For example, a process, a method, a system, a product, or a device that includes a series of steps or units is not limited to the listed steps or units, but optionally further includes other unlisted steps or units, or optionally further includes another inherent step or unit of the process, the method, the product, or the device.

It should be noted that, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example", or the like is intended to present a related concept in a specific manner.

In the descriptions of this application, unless otherwise specified, "a plurality of" means two or more than two. The term "and/or" in this specification describes only an association relationship between associated objects and indicates that there may be three relationships. For example, A and/or B may represent the following three cases: Only A exists, both A and B exist, and only B exists.

In the descriptions of this application, the "indication" may include a direct indication and an indirect indication, or may include an explicit indication and an implicit indication. Information indicated by a piece of information is referred to as to-be-indicated information. In a specific implementation process, there are a plurality of manners of indicating the to-be-indicated information. For example, the to-be-indicated information may be directly indicated, where the to-be-indicated information, an index of the to-be-indicated information, or the like is indicated. For another example, the to-be-indicated information may be indirectly indicated by indicating other information. There is an association relationship between the other information and the to-be-indicated information. For another example, only a part of the to-be-indicated information may be indicated, and the other part of the to-be-indicated information is already known or pre-agreed on. In addition, specific information may alternatively be indicated by using a pre-agreed (for example, stipulated in a protocol) arrangement sequence of various pieces of information, to reduce indication overheads to some extent.

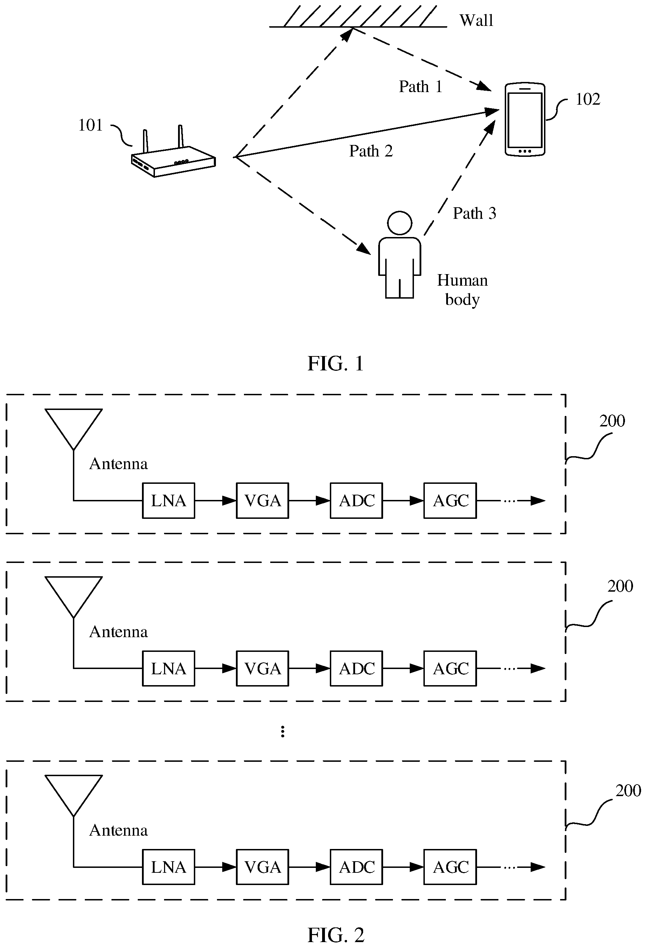

In a wireless communication process, a to-be-sensed target (for example, a human body) may interfere with a radio signal, and consequently a radio channel changes. Therefore, a wireless communication device may sense the target based on CSI, to meet application requirements of wireless sensing such as human body presence detection, posture recognition, fall detection, and intrusion detection. For example, as shown in FIG. 1, because a to-be-sensed target (for example, a wall or a human body) interferes with a signal, signals between a wireless communication device 101 and a wireless communication device 102 may be transmitted through different paths, for example, a path 1, a path 2, a path 3, and the like. Different paths have different contributions to CSI, and the contributions of these paths jointly form the CSI.

For example, FIG. 2 is a diagram of a structure in which a wireless communication device processes a received packet (or referred to as a signal, or a frame, or a signal frame, or the like). As shown in FIG. 2, the wireless communication device may include one or more receive paths 200 (three receive paths are shown in FIG. 2). Each receive path 200 may include various types of components (or referred to as modules or circuits) such as an antenna (antenna), a low noise amplifier (low noise amplifier, LNA), a variable gain amplifier (variable gain amplifier, VGA), an analog to digital converter (analog to digital converter, ADC), and an automatic gain control (automatic gain control, AGC). A direction of an arrow may indicate a data flow direction.

The antenna may be configured to receive and send a signal. In embodiments of this application, a type of the antenna used by the wireless communication device is not limited. The antenna may be in a form of a single antenna, or may be in a form of an antenna array including a plurality of antenna elements. This is not limited in this application. The LNA may be configured to amplify signal power. For example, the LNA may include but is not limited to various types of LNAs such as an external LNA (external LNA, eLNA) and an internal LNA (internal LNA, iLNA). The VGA may also be configured to amplify signal power, and the ADC may be configured to convert an analog signal into a digital signal. The AGC may be configured to automatically adjust a gain of one or more components (for example, an LNA or a VGA) in the receive path 200 based on signal power (or referred to as signal strength), so that power of a signal input to the ADC may remain constant or basically unchanged.

It should be noted that, in embodiments of this application, the components shown in FIG. 2 are merely examples for description, and do not constitute a limitation on this application. In actual application, the receive path 200 may include more or fewer components, or another type of component.

Currently, the wireless communication device may process, through the structure shown in FIG. 2, a signal corresponding to a received sensing packet, to obtain CSI. However, for each received sensing packet, the wireless communication device adjusts a gain of the AGC based on power of a signal corresponding to the sensing packet. In other words, the wireless communication device adjusts the gain of the one or more components in the receive path 200 through the AGC component based on the power of the signal corresponding to the sensing packet, so that the power of the signal corresponding to each sensing packet may be constant or basically unchanged; and then process the signal corresponding to the sensing packet through the components on which gain adjustment is performed, to obtain CSI. In this way, because a bottom layer (or referred to as a physical layer) of the wireless communication device processes the sensing packet, even if no to-be-sensed target interferes with a radio signal between wireless communication devices, CSI obtained from different sensing packets received by one wireless communication device from another wireless communication device is also different, and the CSI fluctuates greatly and has low stability. In addition, when the CSI is used to sense a target, sensing precision is further affected. For example, a static state is determined as an active state.

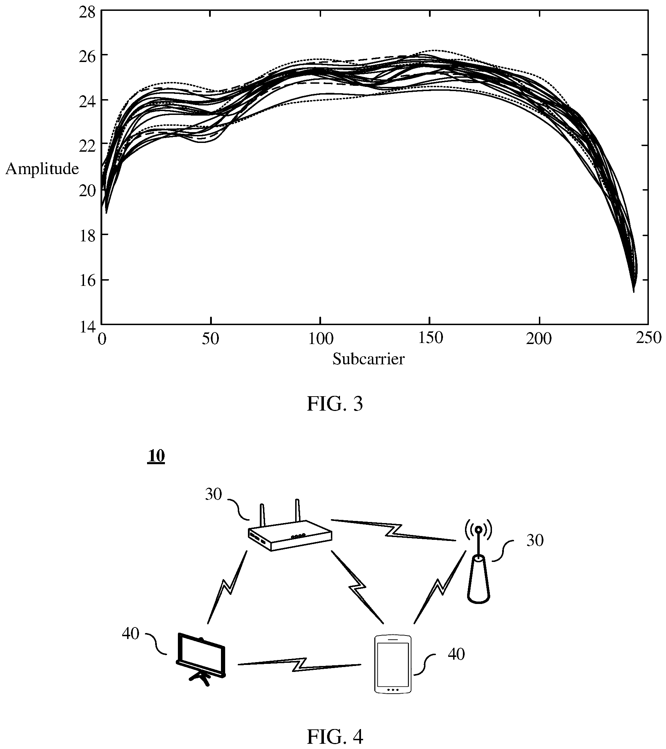

For example, FIG. 3 is a diagram of a result of existing obtained CSI. As shown in FIG. 3, a horizontal axis indicates a subcarrier, a vertical axis indicates an amplitude of CSI, and each curve indicates CSI obtained based on one sensing packet. All sensing packets in FIG. 3 are sent by a same wireless communication device to another wireless communication device. Optionally, when the wireless communication device uses a multi-antenna structure, all the sensing packets in FIG. 3 may be sent by a same transmit antenna of the wireless communication device to a same receive antenna of the another wireless communication device. It can be learned from FIG. 3 that, for a same subcarrier, CSI obtained based on different sensing packets fluctuates greatly and has low stability.

In view of this, this application provides a CSI obtaining method, to improve stability of obtained CSI, and further improve sensing precision. The technical solutions provided in embodiments of this application may be applied to various communication systems, for example, an orthogonal frequency-division multiple access (orthogonal frequency-division multiple access, OFDMA) communication system, a single carrier frequency-division multiple access (single carrier FDMA, SC-FDMA) communication system, a device-to-device (device-to-device, D2D) communication system, an internet of vehicles communication system, a long term evolution (long term evolution, LTE) system, an LTE frequency division duplex (frequency division duplex, FDD) system, an LTE time division duplex (time division duplex, TDD) system, a worldwide interoperability for microwave access (worldwide interoperability for microwave access, WiMAX) communication system, a Wi-Fi communication system, a 5^{th} generation (5^{th} generation, 5G) mobile communication system like a new radio (new radio, NR) system, and a future communication system like a 6^{th} generation (6^{th} generation, 6G) mobile communication system. The terms "system" and "network" may be interchanged with each other.

The foregoing communication systems applicable to this application are only examples for description, and the communication systems applicable to this application are not limited thereto. This is uniformly described herein. Details are not described below again.

FIG. 4 shows a communication system 10 according to an embodiment of this application. The communication system 10 may be a Wi-Fi communication system or another communication system. The communication system 10 includes at least one network device 30 (only two network devices are shown in FIG. 4) and one or more terminal devices 40 (only two terminal devices are shown in FIG. 4) connected to the network device 30. Optionally, communication may be performed between different network devices 30, between different terminal devices 40, and between the network device 30 and the terminal device 40.

In this embodiment of this application, the network device 30 is a device that is located on a network side of the communication system and has a wireless transceiver function, or a chip or a chip system that may be disposed in the device. The network device 30 includes but is not limited to an access point (access point, AP) in a wireless fidelity (wireless fidelity, Wi-Fi) system, for example, a home gateway, a router, a server, a switch, or a bridge. The network device 30 may alternatively be an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB, or a home NodeB, HNB), a baseband unit (baseband unit, BBU), a wireless relay node, a wireless backhaul node, or a transmission point (transmission and reception point, TRP or transmission point, TP). The network device may alternatively be a gNB in a 5G system, for example, a new radio (new radio, NR) system, a transmission point (TRP or TP), one antenna panel or a group of antenna panels (including a plurality of antenna panels) of a base station in the 5G system, or a network node that constitutes the gNB or the transmission point, for example, a baseband unit (BBU), a distributed unit (distributed unit, DU), or a road side unit (road side unit, RSU) having a base station function. Alternatively, the network device 30 may be a device that implements a function of a base station in an internet of things (internet of things, IoT), for example, a device that implements a function of a base station in vehicle-to-everything (vehicle-to-everything, V2X), device-to-device (device-to-device, D2D), machine-to-machine (machine-to-machine, M2M). This is not limited in embodiments of this application.

The terminal device 40 is a terminal that accesses the communication system shown in FIG. 4 and has a wireless transceiver function, or a chip or a chip system that may be disposed in the terminal. The terminal device 40 may alternatively be referred to as a user apparatus, an access terminal, a subscriber unit, a subscriber station, a mobile station, a remote station, a remote terminal, a mobile device, a user terminal, a terminal, a wireless communication device, a user agent, or a user apparatus. The terminal device 40 in embodiments of this application may be a mobile phone (mobile phone), a tablet computer (Pad), a computer with a wireless transceiver function, a virtual reality (virtual reality, VR) terminal device, an augmented reality (augmented reality, AR) terminal device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), a vehicle-mounted terminal, an RSU with a terminal function, or the like. Specific forms of the network device 30 and the terminal device 40 are not specially limited in embodiments of this application, and are merely examples for description herein.

Optionally, the network device 30 and the terminal device 40 in embodiments of this application may alternatively be referred to as communication apparatuses, and each may be a general-purpose device or a dedicated device. This is not specifically limited in embodiments of this application.

It should be noted that the CSI obtaining method provided in embodiments of this application may be applied between any two nodes shown in FIG. 4, for example, between terminal devices, between network devices, or between a terminal device and a network device. For specific implementation, refer to the following method embodiments. Details are not described herein.

It should be noted that, the solutions in embodiments of this application may alternatively be applied to another communication system, and a corresponding name may alternatively be replaced with a name of a corresponding function in the another communication system.

It should be understood that FIG. 4 is merely a simplified diagram of an example for ease of understanding. The communication system may further include another device that is not drawn in FIG. 4.

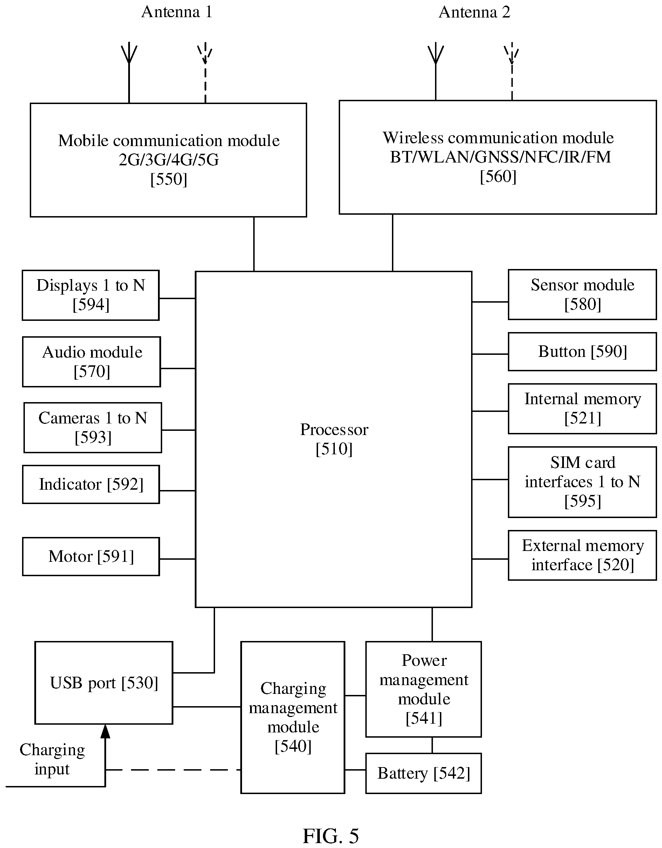

For example, the terminal device 40 is a mobile phone. FIG. 5 is a diagram of a structure of the terminal device 40.

The terminal device 40 may include a processor 510, an external memory interface 520, an internal memory 521, a universal serial bus (universal serial bus, USB) port 530, a charging management module 540, a power management module 541, a battery 542, an antenna 1, an antenna 2, a mobile communication module 550, a wireless communication module 560, an audio module 570, a sensor module 580, a button 590, a motor 591, an indicator 592, a camera 593, a display 594, a subscriber identification module (subscriber identification module, SIM) card interface 595, and the like.

The processor 510 may include one or more processing units. For example, the processor 510 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent devices, or may be integrated into one or more processors.

The controller may generate an operation control signal based on instruction operation code and a time sequence signal, to complete control of instruction reading and instruction execution.

A memory may be further disposed in the processor 510, and is configured to store instructions and data. In some embodiments, the memory in the processor 510 is a cache memory. The memory may store instructions or data just used or cyclically used by the processor 510. If the processor 510 needs to use the instructions or the data again, the processor may directly invoke the instructions or the data from the memory. This avoids repeated access, reduces waiting time of the processor 510, and improves system efficiency.

In some embodiments, the processor 510 may include one or more interfaces, for example, the USB port 530. The USB port 530 is an interface that conforms to a USB standard specification, and may be specifically a mini USB port, a micro USB port, a USB type-C port, or the like. The USB port 530 may be used to connect to a charger to charge the terminal device 40, or may be used to transmit data between the terminal device 40 and a peripheral device, or may be used to connect to a headset for playing audio through the headset. The port may be further used to connect to another device, like an AR device.

The charging management module 540 is configured to receive a charging input from the charger. The charger may be a wireless charger or a wired charger.

The power management module 541 is configured to connect to the battery 542, the charging management module 540, and the processor 510. The power management module 541 receives an input from the battery 542 and/or the charging management module 540, and supplies power to the processor 510, the internal memory 521, the display 594, the camera 593, the wireless communication module 560, and the like.

A wireless communication function of the terminal device 40 may be implemented by using the antenna 1, the antenna 2, the mobile communication module 550, the wireless communication module 560, the modem processor, the baseband processor, and the like.

The antenna 1 and the antenna 2 are configured to transmit and receive an electromagnetic wave signal. Each antenna in the terminal device 40 may be configured to cover one or more communication frequency bands. Different antennas may be further multiplexed, to improve antenna utilization. For example, the antenna 1 may be multiplexed as a diversity antenna of a wireless local area network. In some other embodiments, the antenna may be used in combination with a tuning switch.

The mobile communication module 550 may provide a wireless communication solution that includes 2G/3G/4G/5G or the like and that is applied to the terminal device 40. The mobile communication module 550 may include at least one filter, a switch, a power amplifier, a low noise amplifier (low noise amplifier, LNA), and the like.

The wireless communication module 560 may provide a wireless communication solution that includes a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, or the like and that is applied to the terminal device 40.

In some embodiments, the antenna 1 of the terminal device 40 is coupled to the mobile communication module 550, and the antenna 2 thereof is coupled to the wireless communication module 560, so that the terminal device 40 can communicate with a network and another device by using a wireless communication technology.

The terminal device 40 implements a display function by using the GPU, the display 594, the application processor, and the like. The GPU is a microprocessor for image processing, and is connected to the display 594 and the application processor. The GPU is configured to: perform mathematical and geometric computation, and render an image. The processor 510 may include one or more GPUs, which execute program instructions to generate or change display information.

The display 594 is configured to display an image, a video, and the like. The display 594 includes a display panel. In some embodiments, the terminal device 40 may include one or N displays 594, where N is a positive integer greater than 1.

The terminal device 40 may implement an image shooting function by using the ISP, the camera 593, the video codec, the GPU, the display 594, the application processor, and the like.

The camera 593 is configured to capture a static image or a video. In some embodiments, the terminal device 40 may include one or N cameras 593, where N is a positive integer greater than 1.

The NPU is a neural-network (neural-network, NN) computing processor. The NPU quickly processes input information by referring to a structure of a biological neural network, for example, a transfer mode between human brain neurons, and may further continuously perform self-learning. The NPU can implement applications such as intelligent cognition of the terminal device 40, such as image recognition, facial recognition, speech recognition, and text understanding.

The external memory interface 520 may be configured to connect to an external memory card, for example, a micro SD card, to extend a storage capability of the terminal device 40.

The internal memory 521 may be configured to store computer-executable program code. The executable program code includes instructions. The internal memory 521 may include a program storage region and a data storage region. The program storage region may store an operating system, an application required by at least one function (for example, a voice playing function or an image playing function), and the like. The data storage region may store data (for example, audio data or a phone book) created in a process of using the terminal device 40. The processor 510 performs various function applications and data processing of the terminal device 40 by running the instructions stored in the internal memory 521 and/or the instructions stored in the memory disposed in the processor.

The terminal device 40 can implement an audio function such as music playing or recording through the audio module 570, the application processor, and the like.

The audio module 570 is configured to convert digital audio information into an analog audio signal for output, and is also configured to convert an analog audio input into a digital audio signal. The audio module 570 may be further configured to encode and decode an audio signal. In some embodiments, the audio module 570 may be disposed in the processor 510, or some function modules in the audio module 570 are disposed in the processor 510.

Optionally, the sensor module 580 may include but is not limited to one or more of a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

The button 590 includes a power button, a volume button, and the like. The button 590 may be a mechanical button, or may be a touch button. The terminal device 40 may receive a button input, and generate a button signal input related to a user setting and function control of the terminal device 40.

The motor 591 may generate a vibration prompt.

The indicator 592 may be an indicator light, and may be configured to indicate a charging status and a state of charge change, or may be configured to indicate a message, a missed call, a notification, and the like.

The SIM card interface 595 is used to connect to a SIM card.

It may be understood that the structure shown in embodiments of the present invention does not constitute a specific limitation on the terminal device 40. In some other embodiments of this application, the terminal device 40 may include more or fewer components than those shown in the figure, or some components may be combined, or some components may be divided, or different component arrangements may be used. The components shown in the figure may be implemented by hardware, software, or a combination of software and hardware.

The technical solutions provided in embodiments of this application may be applied to various sensing scenarios, for example, sensing scenarios such as human body presence detection, posture recognition, fall detection, intrusion detection, elderly care, gesture recognition, breathing and sleep monitoring, and indoor head counting.

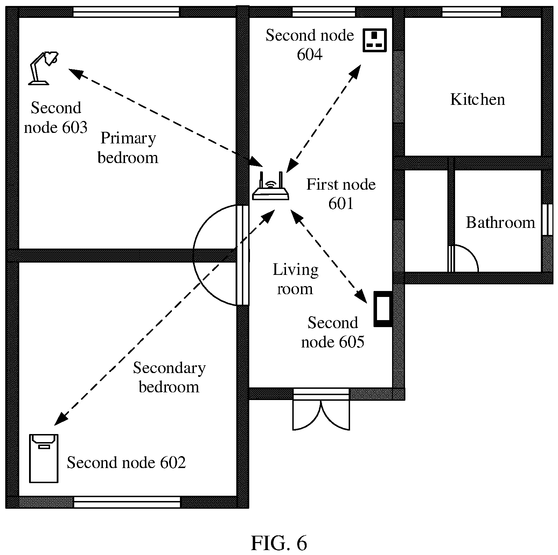

A home environment is used as an example. FIG. 6 shows a sensing scenario in the home environment. As shown in FIG. 6, there may be one first node (or referred to as a sensing center), and the first node is disposed in a living room. For example, the first node may be a router. There may be a plurality of second nodes (or referred to as sensing pairing nodes or sensing pairing devices), and the second nodes may be separately disposed in a bedroom, a bathroom, the living room, a kitchen, and the like. For example, the second nodes may be a mobile phone, a smart socket, a smart desk lamp, an air purifier, and the like. The first node and the second nodes may monitor the entire home environment. A dashed line with an arrow in FIG. 6 indicates a communication link between the first node and a second node. In the scenario shown in FIG. 6, the first node 601 may exchange information with a second node 603 in a primary bedroom, to monitor a sleep status of a user. The first node 601 may exchange information with a second node 604, a second node 605, and the like in the living room, to monitor a condition of the living room. The first node 601 may exchange information with a second node 602 in a secondary bedroom, to monitor a condition of the bedroom.

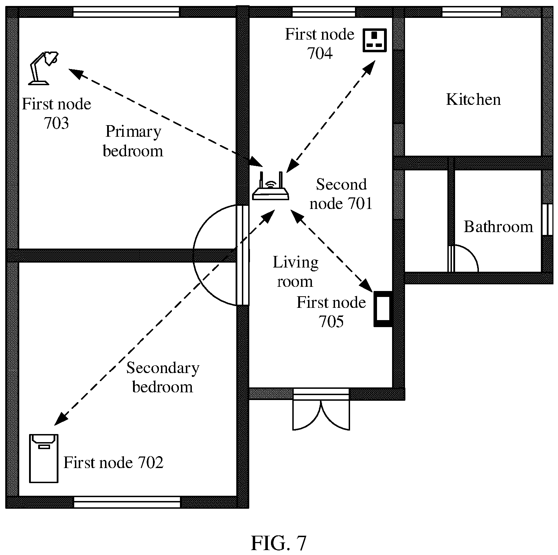

FIG. 7 shows another sensing scenario in the home environment. As shown in FIG. 7, there may be a plurality of first nodes (or referred to as CSI sensing centers), and the first nodes are separately disposed in a bedroom, a bathroom, a living room, a kitchen, and the like. For example, the first nodes may be a mobile phone, a smart socket, a smart desk lamp, an air purifier, and the like. There may be one second node (or referred to as a sensing pairing node or a sensing pairing device), and the second node is disposed in the living room. For example, the second node may be a router. The first nodes and the second node may monitor the living room at different locations. A dashed line with an arrow in FIG. 7 also indicates a communication link between a first node and the second node. In the scenario shown in FIG. 7, a first node 702, a first node 703, a first node 704, and a first node 705 separately exchange information with the second node 701, to monitor a status of the living room.

It may be understood that locations of the first node and the second node shown in FIG. 6 and FIG. 7 are merely examples for description, and do not constitute a limitation on this application.

Optionally, the first node in FIG. 6 and FIG. 7 may be a network device or a terminal device. Similarly, the second node may also be a network device or a terminal device. In this application, a type of the first node and/or a type of the second node is not limited, and a quantity of first nodes and/or a quantity of second nodes is not limited.

It may be understood that a network architecture and a service scenario described in embodiments of this application are intended to describe the technical solutions in embodiments of this application more clearly, and do not constitute a limitation on the technical solutions provided in embodiments of this application. A person of ordinary skill in the art may know that: With the evolution of the network architecture and emergence of new service scenarios, the technical solutions provided in embodiments of this application are also applicable to similar technical problems.

With reference to the accompanying drawings, the following describes in detail the CSI obtaining method provided in embodiments of this application by using an example in which any two nodes shown in FIG. 4 interact with each other.

It should be noted that names of messages, names of parameters in the messages, or the like in the following embodiments of this application are merely examples, and there may be other names in a specific implementation. This is not specifically limited in embodiments of this application.

It may be understood that, in embodiments of this application, a first node and/or a second node may perform some or all steps in embodiments of this application. These steps or operations are merely examples. In embodiments of this application, other operations or variations of various operations may be further performed. In addition, the steps may be performed in a sequence different from a sequence presented in embodiments of this application, and not all the operations in embodiments of this application may be performed.

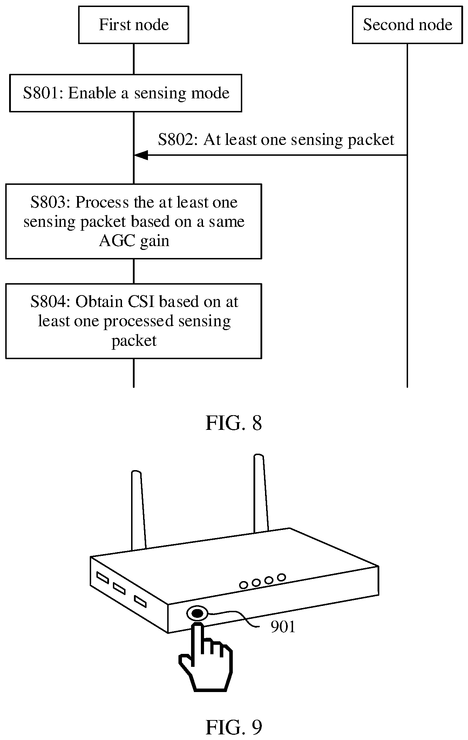

FIG. 8 shows a CSI obtaining method according to an embodiment of this application. The method includes the following steps.

S801: A first node enables a sensing mode.

In this embodiment of this application, the first node may include two operating modes: the sensing mode and a non-sensing mode. When the first node is in the sensing mode, the first node may sense a target based on CSI. When the first node is in the non-sensing mode, the first node may perform normal service communication with another node to transmit service data.

Optionally, the first node may be in the sensing mode by default, or may be in the non-sensing mode by default. When the first node is in the non-sensing mode, the first node may further enable the sensing mode, that is, disable the non-sensing mode, after receiving an instruction indicating to enable the sensing mode.

In some embodiments, the sensing mode of the first node may be enabled by performing an operation on the first node by a user. For example, the user may enable the sensing mode of the first node in various manners such as a gesture, a button, and a voice. For example, as shown in FIG. 9, the first node is a router. The router includes a function button 901 for enabling the sensing mode. The router detects a trigger operation performed by the user on the function button 901, and the router enables the sensing mode in response to the operation. Optionally, the router may further output a reminder message (in various manners such as voice broadcast), to remind the user that the sensing mode is enabled.

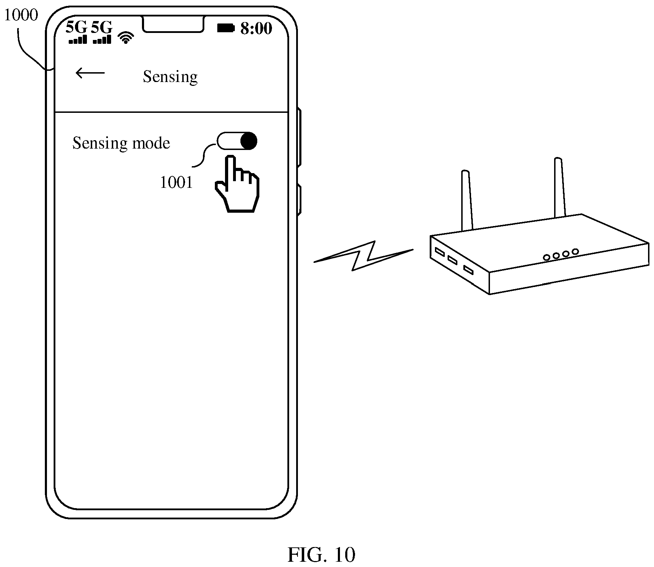

In some other embodiments, the sensing mode of the first node may alternatively be enabled by performing an operation on another device by the user. For example, the first node is a router, and the another device is a mobile phone. FIG. 10 is a diagram in which the user enables the sensing mode of the router through the mobile phone. As shown in FIG. 10, the mobile phone displays a sensing interface 1000. The sensing interface 1000 includes a sensing mode function button 1001. The mobile phone detects an enabling operation performed by the user on the function button 1001. In response to the operation, the mobile phone sends an instruction message (namely, a first message) to the router, where the instruction message indicates the router to enable the sensing mode. After receiving the instruction message, the router enables the sensing mode. Optionally, after the router enables the sensing mode, the mobile phone and/or the router may further output a reminder message, to remind the user that the sensing mode of the router is enabled. Optionally, a communication connection may be established between the mobile phone and the router through Wi-Fi, or certainly, may be established in another manner. This is not specifically limited in this application.

It may be understood that, when the user starts the first node, both an operation performed by the user on the first node and an operation performed by the user on the another device may be referred to as a first operation of the user.

In another embodiment, the sensing mode of the first node may alternatively be automatically enabled periodically or aperiodically.

It should be noted that an occasion and a manner of enabling the sensing mode by the first node are not limited in this application.

Optionally, after enabling the sensing mode, the first node may perform a sensing process one or more times. The first node may periodically perform the sensing process, or may aperiodically perform the sensing process. It may be understood that one sensing process is a process in which the first node continuously receives sensing packets, obtains CSI, and performs one sensing operation. In different sensing scenarios, for example, intrusion detection and human body fall detection, execution duration of one sensing process may be the same or different, and time intervals between two adjacent sensing processes may be the same or different.

S802: A second node sends at least one sensing packet (namely, a first signal frame) to the first node, and correspondingly, the first node receives the at least one sensing packet from the second node.

Optionally, before receiving the at least one sensing packet from the second node, the first node may alternatively first determine the second node.

Optionally, there may be one or more second nodes.

In some embodiments, the first node may determine the second node based on a plurality of preset factors. For example, the preset factor may include but is not limited to one or more of whether a node is a node at a fixed location, a frequency band used by a node (for example, a 2.4 gigahertz (GHz) frequency band is used (or supported), a 5 GHz frequency band is used, or a 2.4 GHz frequency band and a 5 GHz frequency band are used), a protocol (for example, 802.11n or 802.11ax) used by a node, signal strength of a node, a device type of a node (for example, whether the node is a plug-in device, or whether the node is an IOT device or a mobile terminal), a received signal strength indication (received signal strength indication, RSSI) corresponding to a node, and the like. A device type of a node selected by the first node as the second node may be preset, and an RSSI corresponding to the node may be used to determine quality of a communication link between the first node and the node. For example, the first node may preferentially use a node at a fixed location, a node using a 5 GHz frequency band, a node with strong signal strength, a node for which quality of a communication link between the node and the first node is high, or the like as the second node. It may be understood that, when the node at the fixed location is used as the second node, obtained CSI is more stable; and when the node using the 5 GHz frequency band, the node with strong signal strength, the node for which quality of the communication link between the node and the first node is high, or the like is used as the second node, quality of communication between the first node and the second node can be ensured. Therefore, selecting these types of nodes can achieve a better sensing effect. It may be understood that the foregoing preset factors are merely examples for description. In an actual design, the preset factor may be set by a developer based on an actual requirement.

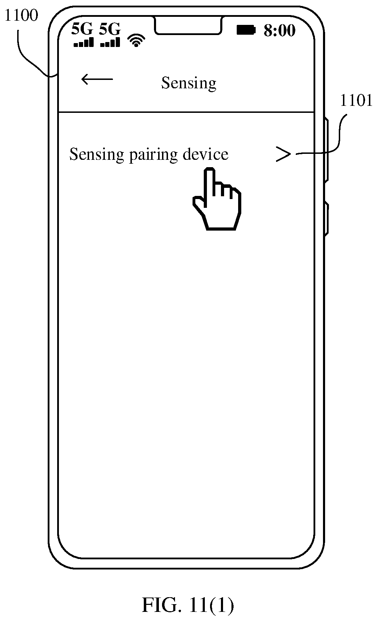

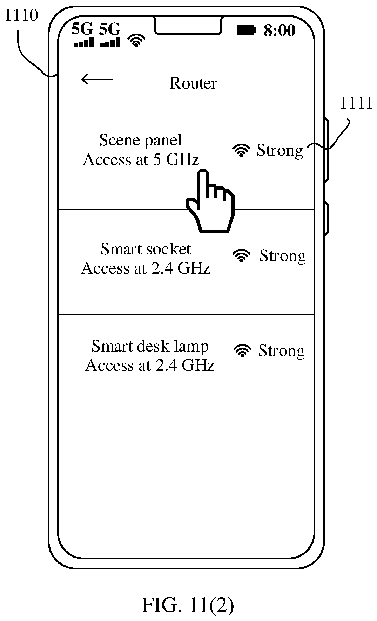

In some other embodiments, the second node may be selected by the user. For example, the user selects the second node through the mobile phone. As shown in FIG. 11(1), the mobile phone displays a sensing interface 1100. The sensing interface 1100 includes a sensing pairing device option 1101. The mobile phone detects a tap operation performed by the user on the sensing pairing device option 1101, and in response to the operation, the mobile phone may display a related interface of the first node. For example, the first node is a router, and the mobile phone may display a router interface 1110 shown in FIG. 11(2). The router interface 1110 includes one or more nodes, for example, a scene panel, a smart socket, and a smart desk lamp. Optionally, signal strength, an accessed frequency band (for example, 2.4 GHz or 5 GHz), and the like of each node may be further displayed on a display region of the node. Optionally, a recommendation message (not shown in the figure) like "Recommended as a sensing pairing device" may be further displayed on the router interface 1110 to recommend, to the user, a device suitable for being used as the second node.

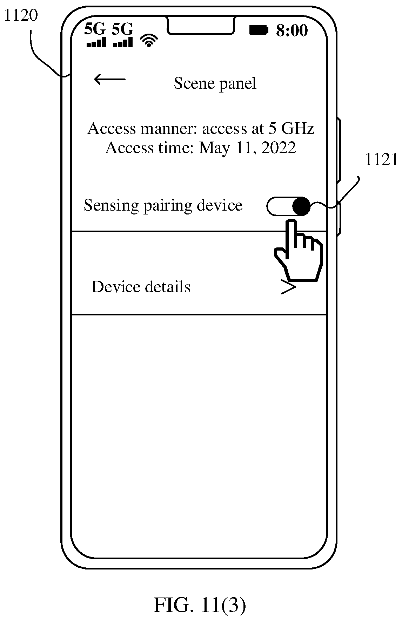

The user may select one or more nodes as the second node as required. For example, the mobile phone detects a tap operation performed by the user on a scene panel 1111. In response to the operation, as shown in FIG. 11(3), the mobile phone may display a scene panel interface 1120. The scene panel interface 1120 includes an on button 1121. The user may select the scene panel as the second node through the on button 1121. The mobile phone detects, for example, a tap operation (namely, a second operation) performed by the user on the on button 1121. In response to the operation, the mobile phone sends notification information (namely, a second message) to the router. The notification information notifies the router that the second node is the scene panel.

Optionally, the scene panel interface 1120 may further include one or more of a frequency band (for example, 2.4 GHz or 5 GHz) at which the scene panel is accessed, access time, device details, and the like.

Optionally, the first node may also receive one or more service packets from the second node. The service packet is a packet transmitted when the first node performs normal service communication with another node. A type of the service packet is not limited in this application.

Optionally, before this step, the second node may first generate at least one sensing packet.

S803: The first node processes the at least one sensing packet based on a same (or fixed) AGC gain.

It may be understood that, with reference to FIG. 2, that the first node processes the at least one sensing packet based on a same AGC gain means that the first node adjusts gains of one or more components (such as an LNA and a VGA) on the receive path 200 to a fixed gain value through an AGC component. Then, these components process the sensing packet based on the adjusted gain value. For different sensing packets from the second node, these components use the same gain.

In some embodiments, for sensing packets from a same second node, the first node may process the sensing packets based on a same AGC gain. In other words, the sensing packets from the same second node correspond to the same AGC gain. For sensing packets from different second nodes, the first node may process the sensing packets based on different AGC gains. In other words, the sensing packets from the different second nodes may correspond to the different AGC gains.

Optionally, AGC gains corresponding to sensing packets from different second nodes may be different. For example, the second nodes are a node 1 to a node 3. An AGC gain corresponding to a sensing packet from the node 1 is 1, an AGC gain corresponding to a sensing packet from the node 2 is 2, and an AGC gain corresponding to a sensing packet from the node 3 is 3. AGC gains corresponding to sensing packets of the node 1 to the node 3 are different from each other. In other words, the AGC gains corresponding to the sensing packets of the nodes are different from each other.

Optionally, AGC gains corresponding to sensing packets of some second nodes may be the same. For example, the second nodes are a node 1 to a node 3. An AGC gain corresponding to a sensing packet from the node 1 is 1, an AGC gain corresponding to a sensing packet from the node 2 is 1, and an AGC gain corresponding to a sensing packet from the node 3 is 2. AGC gains corresponding to sensing packets of the node 1 and the node 2 are the same, but the AGC gains corresponding to the sensing packets of the node 1 and the node 2 and the AGC gain corresponding to the sensing packet of the node 3 are different. For example, the second nodes are a node 1 to a node 5. AGC gains corresponding to sensing packets of the node 1 and the node 2 are the same, and AGC gains corresponding to sensing packets of the node 3 and the node 4 are different. In this case, the AGC gains corresponding to the sensing packets of the node 1 and the node 2, the AGC gains corresponding to the sensing packets of the node 3 and the node 4, and an AGC gain corresponding to a sensing packet of the node 5 are different.

In some other embodiments, for sensing packets from different second nodes, the first node may alternatively process the sensing packets based on the same AGC gain. In other words, the sensing packets from the different second nodes correspond to the same AGC gain.

It may be understood that the AGC gains corresponding to the sensing packets of the foregoing nodes are merely examples for description, and do not constitute a limitation on this application.

In embodiments of this application, a frame format corresponding to a sensing packet may be specifically implemented as a data frame, a management frame, a control frame, or the like. A specific type of the frame format corresponding to the sensing packet is not limited in this application. Optionally, the first node may simultaneously receive packets in a plurality of different frame formats from the second node. One or more specific frame formats of packets that are used as sensing packets by the first node may be agreed on in a protocol. Certainly, the first node and the second node may alternatively pre-agree on a frame format of a sensing packet, and the second node sends only a packet in the pre-agreed frame format to the first node. Correspondingly, the packet in the pre-agreed frame format that is received by the first node from the second node is the sensing packet.

It should be noted that, for different protocols, the sensing packet may correspond to different frame formats.

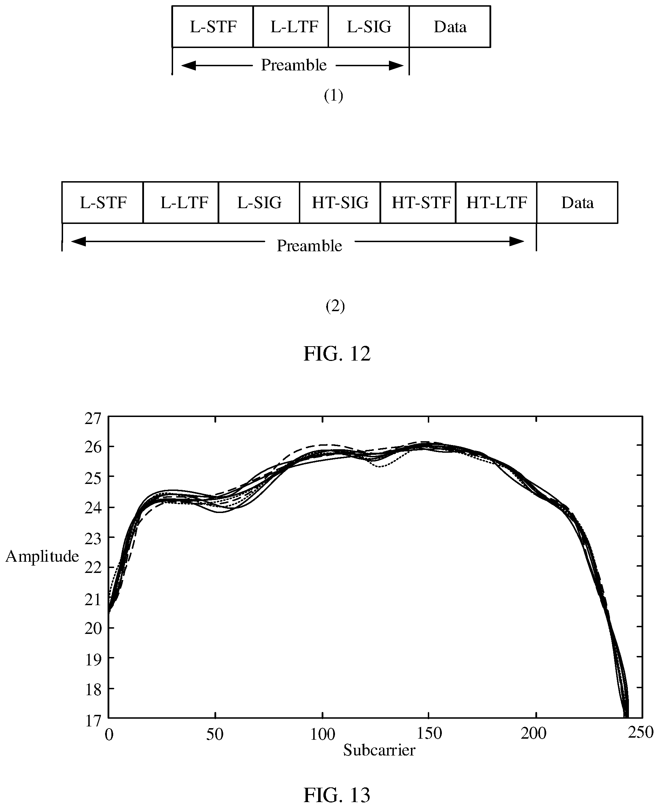

In some protocols, the frame format corresponding to the sensing packet may be implemented in a form shown in (1) in FIG. 12. As shown in (1) in FIG. 12, the frame structure includes a preamble (preamble) part and a data (data) part. The preamble part includes a legacy-short training field (legacy-short training field, L-STF), a legacy-long training field (legacy-long training field, L-LTF), a legacy-signal field (legacy-signal field, L-SIG), and the like.

In some other protocols, the frame format of the sensing packet may be implemented in a form shown in (2) in FIG. 12. As shown in (2) in FIG. 12, the frame structure includes a preamble part and a data part. In addition to fields such as the L-STF, the L-LTF, and the L-SIG shown in (1) in FIG. 12, the preamble part further includes a high throughput-signal field (high throughput-SIG, HT-SIG), a high throughput-short training field (high throughput-STF, HT-STF), a high throughput-long training field (high throughput-LTF, HT-LTF), and the like.

Because frame structures shown in (1) and (2) in FIG. 12 are frame structures in the conventional technology, for functions and related descriptions of parts in the frame structures, refer to the conventional technology. Details are not described in this specification.

It may be understood that the frame formats shown in (1) and (2) in FIG. 12 are merely examples for describing the frame structure of the sensing packet in embodiments of this application. In another protocol or with evolution of a future frame structure, the frame structure of the sensing packet in embodiments of this application may alternatively be implemented in another form. This is not limited in this application.

In some embodiments, the first node may process (that is, perform channel estimation on) the preamble part in the frame structure corresponding to the sensing packet, to obtain CSI. For example, for different sensing packets, the first node may process, based on a same AGC gain, one or more fields in preamble parts in frame structures corresponding to the sensing packets, to obtain CSI.

For example, when a sensing packet uses the frame structure shown in (1) in FIG. 12, for different sensing packets, the first node may process L-STFs, L-LTFs, and L-SIGs based on a same AGC gain. AGC gains corresponding to the L-STFs, the L-LTFs, and the L-SIGs may be the same. CSI obtained based on processed L-LTFs may be used to sense the target.

Optionally, in this example, after the first node obtains the CSI based on the processed L-LTFs (namely, first fields), the first node may further correct the CSI based on some information (for example, a frequency offset obtained through estimation) obtained by processing the L-SIG fields, to improve accuracy of the obtained CSI.

For example, when a sensing packet uses the frame structure shown in (2) in FIG. 12, in a possible example, for different sensing packets, the first node may process HT-STFs, HT-LTFs, and data parts based on a same AGC gain, where AGC gains corresponding to the HT-STFs, the HT-LTFs, and the data parts may be the same. The first node may process L-STFs, L-LTFs, L-SIGs, and HT-SIGs based on different AGC gains, where AGC gains corresponding to the L-STFs, the L-LTFs, the L-SIGs, and the HT-SIGs may be the same. CSI obtained based on processed HT-STFs may be used to sense the target.

Optionally, in this example, after the first node obtains CSI based on processed HT-LTFs (namely, second fields), the first node may further correct the CSI based on some information (for example, a frequency offset obtained through estimation) obtained by processing the data parts, to improve accuracy of the obtained CSI.

In another possible example, for different sensing packets, the first node may process HT-STFs, HT-LTFs, and data parts based on different AGC gains, where AGC gains corresponding to the HT-STFs, the HT-LTFs, and the data parts may be the same. The first node may process L-STFs, L-LTFs, L-SIGs, and HT-SIGs based on a same AGC gain, where AGC gains corresponding to the L-STFs, the L-LTFs, the L-SIGs, and the HT-SIGs may be the same. CSI obtained based on processed L-LTFs may be used to sense the target.

Similarly, in this example, after the first node obtains the CSI based on the processed L-LTFs, the first node may further correct the CSI based on some information (for example, a frequency offset obtained through estimation) obtained by processing the L-SIG fields, to improve accuracy of the obtained CSI.

In still another possible example, for different sensing packets, the first node may process HT-STFs, HT-LTFs, and data parts based on a same AGC gain, where AGC gains corresponding to the HT-STFs, the HT-LTFs, and the data parts may be the same. The first node may also process L-STFs, L-LTFs, L-SIGs, and HT-SIGs based on a same AGC gain, where AGC gains corresponding to the L-STFs, L-LTFs, L-SIGs, and the HT-SIGs may be the same. CSI obtained based on processed HT-STFs may be used to sense the target, and/or CSI obtained based on processed L-LTFs may be used to sense the target. Optionally, the AGC gains corresponding to the HT-STFs, the HT-LTFs, and the data parts may be the same as or different from the AGC gains corresponding to the L-STFs, the L-LTFs, the L-SIGs, and the HT-SIGs.

Similarly, in this example, after the first node obtains the CSI based on the processed L-LTFs, the first node may further correct the CSI based on some information (for example, a frequency offset obtained through estimation) obtained by processing the L-SIG fields, to improve accuracy of the obtained CSI, and/or after the first node obtains CSI based on processed HT-LTFs, the first node may further correct the CSI based on some information (for example, a frequency offset obtained through estimation) obtained by processing the data parts, to improve accuracy of the obtained CSI.

It may be understood that in some protocols, for example, in 802.11n, an L-LTF and an HT-LTF have a same subcarrier spacing, and occupy a same quantity of subcarriers. In comparison with the L-LTF, the HT-LTF may be used to obtain CSI corresponding to a plurality of spatial flows, and the obtained CSI is more abundant. In some other protocols, for example, in 802.11ax, an L-LTF and an HT-LTF have different subcarrier spacings, and occupy different quantities of subcarriers. In comparison with the L-LTF, the HT-LTF may occupy more subcarriers. Therefore, more accurate CSI can be obtained based on the HT-LTF.

In the foregoing examples, the AGC gains corresponding to the HT-STFs, the HT-LTFs, and the data parts are the same, and the AGC gains corresponding to the L-STFs, the L-LTFs, the L-SIGs, and the HT-SIGs are the same. With evolution of future technologies, the AGC gains corresponding to the HT-STFs, the HT-LTFs, and the data parts may alternatively be different, and/or the AGC gains corresponding to the L-STFs, the L-LTFs, the L-SIGs, and the HT-SIGs may alternatively be different. This is not limited in this application.

For example, when a sensing packet uses the frame structure shown in (1) in FIG. 12, for different sensing packets, the first node may process L-LTFs based on a same AGC gain, where CSI obtained based on processed L-LTFs may be used to sense the target. For example, AGC gains corresponding to the L-LTFs of the different sensing packets are all 1. For other fields than the L-LTFs, the first node may process the fields based on a same AGC gain, or may process the fields based on different AGC gains. For example, AGC gains corresponding to L-STFs and/or L-SIGs of some sensing packets are 2, and AGC gains corresponding to L-STFs and/or L-SIGs of some sensing packets are 1.

For another example, when a sensing packet uses the frame structure shown in (2) in FIG. 12, for different sensing packets, the first node may process HT-LTFs based on a same AGC gain, where CSI obtained based on processed HT-LTFs may be used to sense the target. For example, AGC gains corresponding to HT-LTFs of different sensing packets are all 1. For other fields than the HT-LTFs, the first node may process the fields based on a same AGC gain, or may process the fields based on different AGC gains. For example, AGC gains corresponding to one or more of L-STFs, L-LTFs, L-SIGs, HT-SIGs, and HT-STFs of some sensing packets are 2, and AGC gains corresponding to one or more of L-STFs, L-LTFs, L-SIGs, HT-SIGs, and HT-STFs of some sensing packets are 1.

Certainly, when a sensing packet uses the frame structure shown in (2) in FIG. 12, for different sensing packets, the first node may process L-LTFs based on a same AGC gain, where CSI obtained based on processed L-LTFs may be used to sense the target. This is not limited in this application.

It should be noted that in this application, types of fields processed by the first node based on a same AGC gain are not limited, and a specific quantity of fields is not limited either.

S804: The first node obtains CSI based on at least one processed sensing packet.

The first node may sense the target based on the obtained CSI.

For example, FIG. 13 is a diagram of a CSI result obtained according to the CSI obtaining method provided in embodiments of this application. As shown in FIG. 13, a horizontal axis indicates a subcarrier, a vertical axis indicates an amplitude of CSI, and each curve indicates CSI obtained based on one sensing packet. All sensing packets in FIG. 13 are sent by a same second node to the first node. In addition, when the first node and the second node use a multi-antenna structure, all the sensing packets in FIG. 13 may be sent by a same transmit antenna of the second node to a same receive antenna of the first node. It can be learned from FIG. 13 that, in comparison with FIG. 3, for a same subcarrier, CSI obtained based on different sensing packets fluctuates slightly and is more stable.

According to the foregoing solution, the first node in the sensing mode may process different sensing packets based on a same AGC gain, so that impact of bottom-layer processing of the first node can be well suppressed, and obtained CSI is more stable and can more truly reflect a channel state of an air interface channel. In addition, when the target is sensed based on the CSI with high stability, sensing precision can be further improved. For example, states (for example, a moving state and a static state) of the target are better distinguished between each other, and a posture (for example, a gesture or a fall) is better recognized.

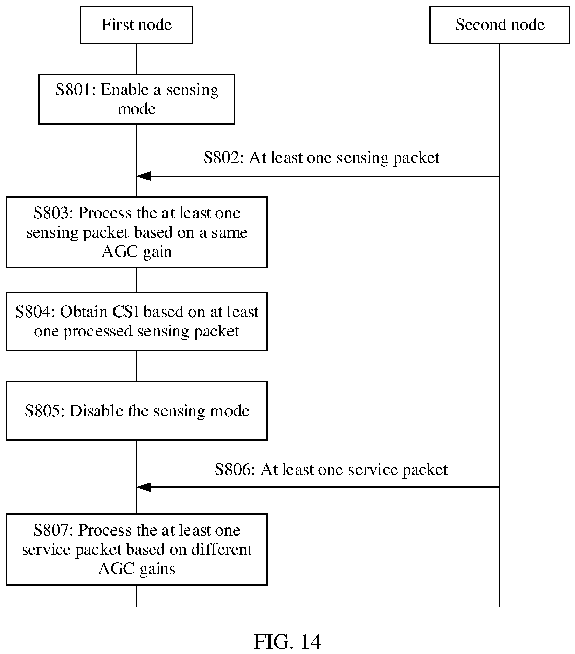

Optionally, as shown in FIG. 14, the method shown in FIG. 8 may further include the following step S805 to step S807.

S805: The first node disables the sensing mode.

It may be understood that, that the first node disables the sensing mode means that the first node enables the non-sensing mode.

In some embodiments, the first node may automatically disable the sensing mode. For example, when determining that a preset condition is currently met, the first node automatically disables the sensing mode. For example, the preset condition may include but is not limited to one or more of the following: time for being in the sensing mode meets preset duration, a quantity of times of performing the sensing process meets a preset quantity of times, a quantity of received sensing packets meets a preset quantity, time in which there is no signal interaction with the second node meets preset duration, and the like.

In some other embodiments, the user may alternatively disable the sensing mode of the first node. Similar to a manner of enabling the sensing mode of the first node, the sensing mode of the first node may be disabled by performing an operation on the first node by the user. For example, the user may disable the sensing mode of the first node in various manners such as a gesture, a button, and a voice. FIG. 9 is still used as an example. The router detects a trigger operation performed by the user on the function button 901. In response to the operation, the router disables the sensing mode, that is, enables the non-sensing mode. Certainly, the router may alternatively output a reminder message (for example, in various manners such as voice broadcast), to remind the user that the sensing mode is disabled. This is not limited in this application.

Alternatively, the sensing mode of the first node may be disabled by an operation performed by the user on another device. FIG. 10 is still used as an example. The mobile phone detects a disabling operation performed by the user on the function button 1001. In response to the operation, the mobile phone sends an instruction message to the router. The instruction message indicates the router to disable the sensing mode. After receiving the instruction message, the router disables the sensing mode. Certainly, the router and/or the mobile phone may also output a reminder message, to remind the user that the sensing mode of the router is disabled.

It should be noted that an occasion and a manner of disabling the sensing mode by the first node are not limited in this application either.

It may be understood that, in embodiments of this application, each interface is merely a diagram, and does not constitute a limitation on this application. In actual application, each interface may include more or less content, or more or fewer interfaces may be included. This is uniformly described herein.

S806: The first node receives at least one service packet (namely, a second signal frame) from the second node.

Optionally, the service packet and the sensing packet may use a same frame format, or may use different frame formats. This is not limited in this application.

Optionally, the second node in this step may be the same as or different from the second node in step S802. In FIG. 14, an example in which the second node in this step is the same as the second node in step S802 is used.

Optionally, before this step, the second node may first generate the at least one service packet.

S807: The first node processes the at least one service packet based on different (or dynamic) AGC gains.

Similarly, with reference to FIG. 2, that the first node processes the at least one service packet based on different AGC gains means that the first node dynamically adjusts a gain of one or more components on the receive path 200 through the AGC component, and then these components process the service packet based on adjusted gain.

In other words, the first node may adjust a gain of one or more components on the receive path 200 through the AGC component based on power of a signal corresponding to each service packet, so that the power of the signal corresponding to each service packet remains constant. It may be understood that, because initial power of signals corresponding to different service packets received by the first node may be different, AGC gains used by the first node are also different. In other words, different service packets from a same second node may correspond to different AGC gains. Service packets of different second nodes may correspond to a same AGC gain or different AGC gains.

Specifically, the AGC gains corresponding to the service packets from the same second node may be different from each other, or may be partially the same. For example, service packets received by the first node from a same second node include a packet 1 to a packet 10. AGC gains corresponding to the packet 1 to the packet 10 may be different from each other. Alternatively, AGC gains corresponding to the packet 1 to the packet 5 are the same, AGC gains corresponding to the packet 6 to the packet 10 are different from each other, and the AGC gains corresponding to the packet 1 to the packet 5 are also different from that of the packet 6 to the packet 10. Alternatively, AGC gains corresponding to the packet 1 to the packet 3 are the same, AGC gains corresponding to the packet 4 to the packet 6 are the same, AGC gains corresponding to the packet 7 to the packet 10 are different from each other, and the AGC gains corresponding to the packet 1 to the packet 3, the AGC gains corresponding to the packet 4 to the packet 6, and the AGC gains corresponding to the packet 7 to the packet 10 are different from each other.

Optionally, step S805 to step S807 may be performed after step S804, or may be performed before step S801. This is not limited in this application.

According to this solution, when normal service communication is performed between the first node and another node the first node may process each service packet based on a corresponding AGC gain, so that power of a signal corresponding to each service packet may be constant or basically unchanged. In this way, communication performance during the service communication can be ensured.

The following provides a manner of determining an AGC gain corresponding to a sensing packet.

In some embodiments, the first node may determine, based on an AGC gain corresponding to at least one service packet from one second node, an AGC gain corresponding to a sensing packet from the second node. For example, an AGC gain corresponding to one of the service packets is used as an AGC gain corresponding to all the sensing packets. Alternatively, an AGC gain that is of the service packet and that appears a largest quantity of times is used as an AGC gain corresponding to all the sensing packets. Alternatively, an average value, a median, or the like of the AGC gain corresponding to the at least one service packet is used as an AGC gain corresponding to all the sensing packets. The at least one service packet may be continuously received service packets, or may not be continuously received service packets. This is not specifically limited in this application.

Optionally, in embodiments, the service packets may be received by the first node from the second node when the first node is in the non-sensing mode. To be specific, the first node receives the service packets from the second node when the first node is in the non-sensing mode, and processes the service packets based on different AGC gains, to determine one AGC gain. Subsequently, when the first node in the sensing mode receives sensing packets from the second node, the first node may process different sensing packets based on the determined AGC gain.

In some other embodiments, before receiving the sensing packet from the second node, the first node may first receive a specific quantity of target packets from the second node. The first node may first process these target packets based on different AGC gains, then determine one AGC gain based on the AGC gains corresponding to these target packets, and subsequently, when receiving the sensing packet, process the sensing packet based on the AGC gain. Optionally, the target packets herein may be sensing packets and/or service packets. In other words, when the first node is in the sensing mode, the first node may receive both a sensing packet and a service packet.

In some possible scenarios, the obtained CSI may be affected by factors such as different temperatures and different environments (for example, a placement location of an object in a room). Therefore, for sensing packets from a same second node, the first node may further periodically update an AGC gain corresponding to the sensing packets.

In some embodiments, the first node may set a sensing cycle. In a same sensing cycle, the first node may process sensing packets from a second node based on a same AGC gain. In different sensing cycles, the first node may process sensing packets from the second node based on different AGC gains. In other words, the first node may update an AGC gain used in a previous sensing cycle.

Optionally, the sensing cycle may be specifically implemented as one or more of the following: preset duration; a first threshold that a quantity of sensing packets received by the first node from the second node meets; and a second threshold that a total quantity of sensing packets and service packets received by the first node from the second node meets. Optionally, the service packet may be received by the first node in the sensing mode, or may be received by the first node in the non-sensing mode.

Optionally, when the first node is in the sensing mode, one or more sensing cycles may be included. Alternatively, one sensing cycle may include one or more cases in which the first node is in the sensing mode, and/or one or more cases in which the first node is in the non-sensing mode. The sensing cycle is not specifically limited in this application. Optionally, one sensing cycle may alternatively include one or more sensing processes.

In some possible implementations, in different sensing cycles, the first node may process target packets (namely, third signal frames) from the second node based on different AGC gains. The first node may determine, based on the AGC gains corresponding to the received target packets, an AGC gain corresponding to a sensing packet to be received in a next sensing cycle. Alternatively, in one sensing cycle, the first node may process target packets from the second node based on different AGC gains. The first node may determine, based on the AGC gains corresponding to the received target packets, an AGC gain corresponding to a sensing packet to be received in a current sensing cycle. Here, for descriptions of the target packets, refer to the foregoing descriptions.

Certainly, the first node may alternatively adjust, based on an AGC gain used in a previous sensing cycle or previous several sensing cycles, an AGC gain used in the current sensing cycle.

In some other embodiments, the first node may further update a currently used same AGC gain when determining that a probability (or referred to as bit error rate) that an error occurs when a sensing packet is parsed increases, for example, is greater than a preset probability. For example, when the first node is in the sensing mode, the first node receives sensing packets in a (a is a positive real number) seconds from the second node based on a same AGC gain. If the first node determines that a bit error rate increases when the first node receives the sensing packets based on the currently same AGC gain, the first node starts to receive sensing packets in b (b is a positive real number) seconds from the second node based on different AGC gains, and then the first node may update the used same AGC gain based on one or more of the AGC gains corresponding to the sensing packets in the b seconds, and then continue to receive a sensing packet based on an updated AGC gain. The a seconds and the b seconds may alternatively be replaced with quantities, for example, c or d, where c and d are positive real numbers. Optionally, a, b, c, and d may all be set by the developer based on an actual requirement.

It may be understood that, that the first node receives sensing packets from the second node based on different AGC gains means that the first node may process each sensing packet based on a corresponding AGC gain based on power of a signal corresponding to the sensing packet, where different sensing packets may correspond to different AGC gains.

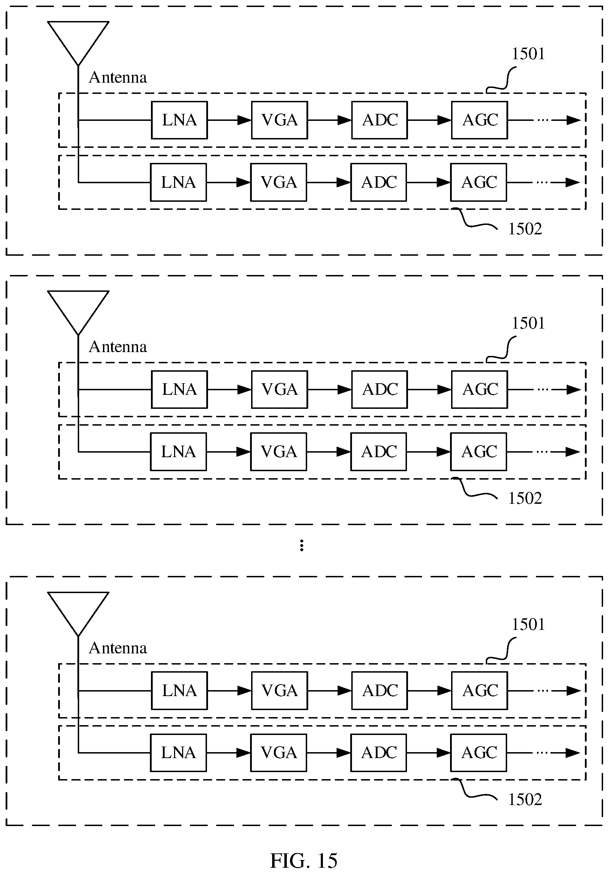

In some other embodiments, the first node may further set a plurality of receive channels to receive a same sensing packet. For some of the receive channels, the first node processes the sensing packet from the second node based on a same AGC gain. For other receive channels, the first node processes the sensing packet from the second node based on different AGC gains. For example, FIG. 15 shows only two receive channels: a receive channel 1501 and a receive channel 1502. In other words, the receive channel 200 shown in FIG. 2 may be specifically implemented in a form of a plurality of channels. For the receive channel 1501, the first node may process a sensing packet from the second node based on a same AGC gain. For the receive channel 1502, the first node may process the sensing packet from the second node based on different AGC gains, and subsequently, the first node may update, based on the AGC gain used by the receive channel 1502, the AGC gain used by the receive channel 1501.

It should be noted that the foregoing manners of updating the AGC gain corresponding to the sensing packet are merely example for descriptions, and do not constitute a limitation on this application. A manner and an occasion of updating the AGC gain corresponding to the sensing packet are not limited in this application.

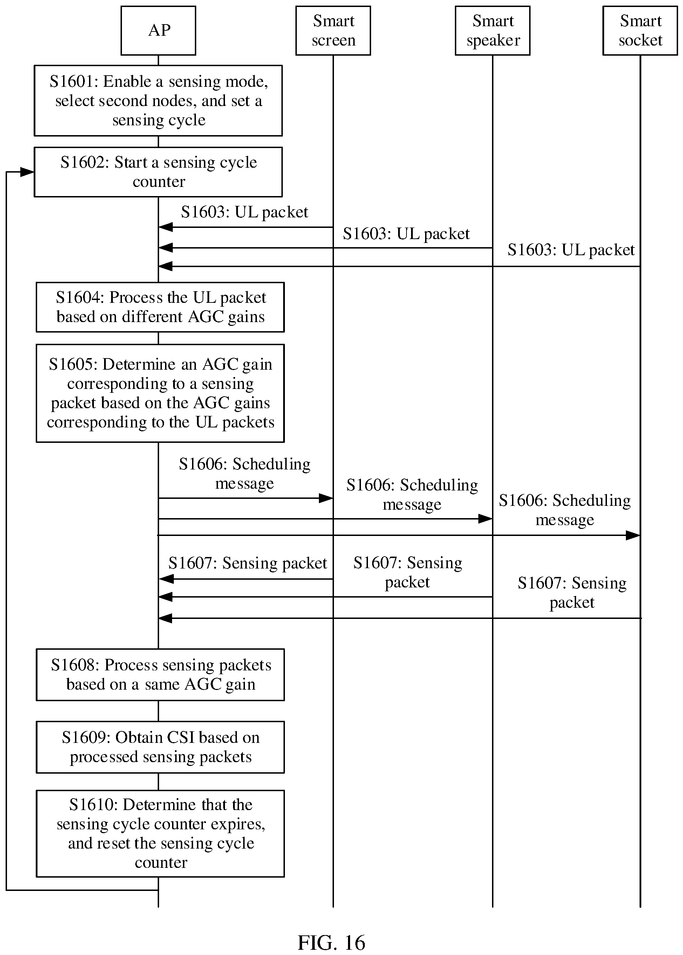

For example, the first node is an AP, and the second nodes are a smart screen, a smart speaker, and a smart socket. FIG. 16 shows another CSI obtaining method according to an embodiment of this application. The method includes the following steps.

S1601: The AP enables a sensing mode, selects the second nodes, and sets a sensing cycle.

The second nodes are the smart screen, the smart speaker, and the smart socket. For a manner of selecting the second nodes and setting the sensing cycle, refer to the foregoing descriptions.

S1602: The AP starts a sensing cycle counter.

When the sensing cycle is set to preset duration, a parameter calculated by the sensing cycle counter is time. When the sensing cycle is set to a preset quantity of packets, the parameter calculated by the sensing cycle counter is a quantity of packets. Optionally, the preset quantity of packets may be a quantity of sensing packets, or may be a total quantity of sensing packets and service packets.

S1603: The smart screen, the smart speaker, and the smart socket each send an uplink (uplink, UL) packet to the AP, and correspondingly, the AP receives UL packets from the smart screen, the smart speaker, and the smart socket.

Optionally, the UL packet may be a sensing packet, or may be a service packet. This is not limited in this application.

S1604: The AP processes the UL packet based on different AGC gains.

The AP may separately process the UL packets from the smart screen, the smart speaker, and the smart socket. For the smart screen, the AP processes the UL packet based on different AGC gains. Similarly, the AP processes the UL packets from the smart speaker and the smart socket based on different AGC gains.

That the AP processes an UL packet from the smart screen based on different AGC gains means that, for each UL packet from the smart screen, the AP may process the UL packet based on a corresponding AGC gain based on power of a signal corresponding to the UL packet. Different UL packets from the smart screen may correspond to different AGC gains. Similarly, for the meaning of processing, by the AP, the UL packets from the smart speaker and the smart socket based on different AGC gains, refer to the foregoing meaning.

It may be understood that, when the AP is in the sensing mode, in one sensing cycle, the AP may first process some UL packets from a same second node based on different AGC gains. Duration in which the AP receives the UL packets and a quantity of UL packets received by the AP are not specifically limited in this application.

S1605: The AP determines an AGC gain corresponding to a sensing packet based on the AGC gains corresponding to the UL packets.

For the smart screen, the smart speaker, and the smart socket, the AP may separately determine, based on AGC gains corresponding to the UL packets of the smart screen, the smart speaker, and the smart socket, AGC gains corresponding to sensing packets of the smart screen, the smart speaker, and the smart socket. For specific implementation of this step, refer to the foregoing related descriptions of the manner of determining the AGC gain corresponding to the sensing packet.

The AGC gains corresponding to the sensing packets from the smart screen, the smart speaker, and the smart socket may be the same or may be different. Sensing packets from the smart screen correspond to a same AGC gain. Similarly, sensing packets from the smart speaker correspond to a same AGC gain, and sensing packets from the smart speaker the smart socket correspond to a same AGC gain.

S1606: The AP separately sends a scheduling message to the smart screen, the smart speaker, and the smart socket (optional).

The scheduling message is used to schedule the sensing packets from the smart screen, the smart speaker, and the smart socket.

In another embodiment, the AP may alternatively not send the scheduling message to the smart screen, the smart speaker, and the smart socket, but directly receive the sensing packets from the smart screen, the smart speaker, and the smart socket.

Optionally, when the AP is in a non-sensing mode, the AP may send a scheduling message to the second node to schedule a service packet. Certainly, the AP may alternatively not send the scheduling message to the second node, but directly receive the service packet from the second node. This is not specifically limited in this application.

S1607: The smart screen, the smart speaker, and the smart socket each send the sensing packets to the AP, and correspondingly, the AP receives the sensing packets from the smart screen, the smart speaker, and the smart socket.

S1608: The AP processes the sensing packets based on a same AGC gain.

The AP may separately process the sensing packets from the smart screen, the smart speaker, and the smart socket. For the sensing packets from the smart screen, the AP processes the packets based on the same AGC gain. For the sensing packets from the smart speaker and the smart socket, a method for processing the sensing packets by the AP is similar. It may be understood that the same AGC gain may be obtained according to step S1605.

S1609: The AP obtains CSI based on processed sensing packets.

The AP may separately obtain CSI corresponding to the smart screen, the smart speaker, and the smart socket. Optionally, the CSI corresponding to the smart screen, the smart speaker, and the smart socket may be different.

S 1610: The AP determines that the sensing cycle counter expires, and resets the sensing cycle counter.

After resetting the sensing cycle counter, the AP returns to perform step S1602, that is, the AP starts a process of a new sensing cycle.

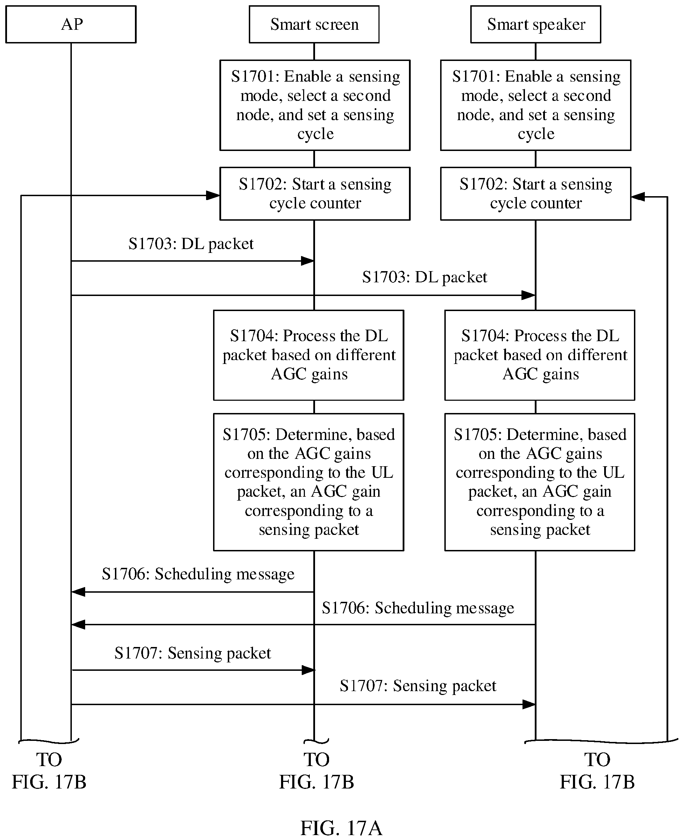

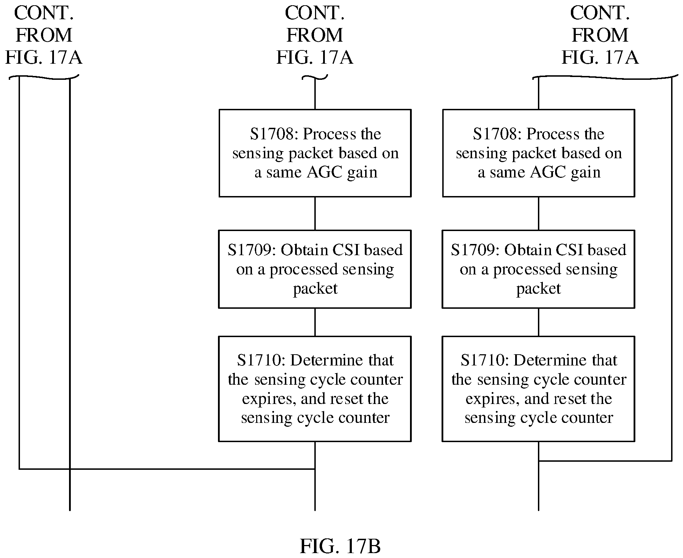

For example, the first nodes are a smart screen and a smart speaker, and the second node is an AP. FIG. 17A and FIG. 17B show another CSI obtaining method according to an embodiment of this application. The method includes the following steps.

S1701: The smart screen and the smart speaker each enable a sensing mode, select the second node, and set a sensing cycle.

The second node is the AP. For a manner of selecting the second node and setting the sensing cycle, still refer to the foregoing descriptions.

S1702: The smart screen and the smart speaker each start a sensing cycle counter.

S1703: The AP sends a downlink (downLink, DL) packet to the smart screen and the smart speaker, and correspondingly, the smart screen and the smart speaker each receive the DL packet from the AP.

Optionally, the DL packet may be a sensing packet, or may be a service packet. This is not limited in this application either.

S1704: The smart screen and the smart speaker each process the DL packet from the AP based on different AGC gains.

That the smart screen processes the DL packet from the AP based on different AGC gains means that, for each DL packet from the AP, the smart screen may process the DL packet based on a corresponding AGC gain based on power of a signal corresponding to the DL packet. Different DL packets from the AP may correspond to different AGC gains. Similarly, the meaning of processing, by the smart speaker, the DL packet from the AP based on different AGC gains is similar to the foregoing meaning.

S1705: The smart screen and the smart speaker each determine, based on the AGC gains corresponding to the DL packet, an AGC gain corresponding to a sensing packet.

The smart screen may determine, based on an AGC gain used when the smart screen processes one or more DL packets from the AP, a corresponding gain used when the smart screen processes a sensing packet of the AP. A same AGC gain may be used when different sensing packets from the AP are processed. Similarly, a case in which the smart speaker determines, based on the AGC gains corresponding to the DL packet, an AGC gain corresponding to the sensing packet is similar. For specific implementation of this step, refer to the foregoing related descriptions of the manner of determining the AGC gain corresponding to the sensing packet.

It may be understood that, when the smart screen (or the smart speaker) is in the sensing mode and in one sensing cycle, the smart screen (or the smart speaker) may first process some DL packets from a same AP based on different AGC gains. In this application, duration in which the smart screen (or the smart speaker) receives the DL packets and a quantity of DL packets received by the smart screen (or the smart speaker) are not specifically limited either.

S1706: The smart screen and the smart speaker each send a scheduling message to the AP (optional).

The scheduling message is used to schedule a sensing packet from the AP.

In another embodiment, the smart screen (or the smart speaker) may alternatively not send the scheduling message to the AP, but directly receive the sensing packet from the AP.

Optionally, when the smart screen (or the smart speaker) is in a non-sensing mode, the smart screen (or the smart speaker) may send a scheduling message to the AP to schedule a service packet. Certainly, the smart screen (or the smart speaker) may alternatively not send the scheduling message to the AP, but directly receive the service packet from the AP. This is not specifically limited in this application.

S1707: The AP separately sends the sensing packet to the smart screen and the smart speaker, and correspondingly, the smart screen and the smart speaker receive the sensing packet from the AP.

S1708: The smart screen and the smart speaker each process the sensing packet based on a same AGC gain.

It may be understood that the same AGC gain may be obtained according to step S1705. For different sensing packets from the AP, the smart screen may process the different sensing packets based on a same AGC gain. Similarly, the smart speaker may also process the different sensing packets based on a same AGC gain. Optionally, AGC gains used by the smart screen and the smart speaker may be the same or different.

S1709: The smart screen and the smart speaker each obtain CSI based on processed sensing packet.

The CSI obtained by the smart screen may be different from the CSI obtained by the smart speaker.

S1710: The smart screen and the smart speaker each reset the sensing cycle counter.

After resetting the sensing cycle counter, the smart screen and the smart speaker returns to perform step S1702, that is, the smart screen and the smart speaker each start a process of a new sensing cycle.

The foregoing mainly describes the solutions provided in embodiments of this application from the perspective of the methods. It may be understood that, to implement the foregoing functions, the communication apparatus (for example, the first node or the second node) includes corresponding hardware structures and/or software modules for performing the functions. With reference to the units and algorithm steps in the examples described in embodiments disclosed in this application, embodiments of this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation falls beyond the scope of the technical solutions in embodiments of this application.

In embodiments of this application, the communication apparatus may be divided into function modules based on the foregoing method examples. For example, function modules may be obtained through division based on corresponding functions, or two or more functions may be integrated into one proces sing unit. The integrated unit may be implemented in a form of hardware, or may be implemented in a form of a software function module. It should be noted that, in embodiments of this application, division into units is an example, and is merely logical function division. In actual implementation, another division manner may be used.

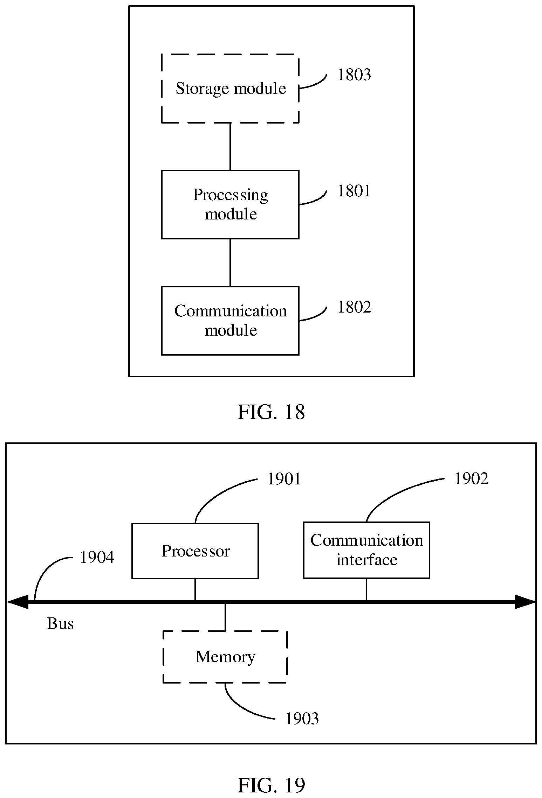

FIG. 18 is a communication apparatus according to an embodiment of this application. The communication apparatus includes a processing module 1801 and a communication module 1802.

In a possible example, the communication apparatus is a first node. The processing module 1801 is configured to support the first node in performing step S801, step S803, and step S804 in FIG. 8, and/or the processing module 1801 is configured to support the first node in performing step S801, step S803 to step S805, and step S807 in FIG. 14 and/or another processing operation that needs to be performed by the first node in embodiments of this application. The communication module 1802 is configured to support the first node in performing step 802 in FIG. 8, and/or the communication module 1802 is configured to support the first node in performing step 802 and step S806 in FIG. 14 and/or another communication operation that needs to be performed by the first node in embodiments of this application.

In another possible example, the communication apparatus is a second node. The processing module 1801 is configured to support the second node in generating at least one sensing packet and/or at least one service packet, and/or another processing operation that needs to be performed by the second node in embodiments of this application. The communication module 1802 is configured to support the second node in performing step S802 in FIG. 8, and/or the communication module 1802 is configured to support the second node in performing step S802 and step S806 in FIG. 14 and/or another communication operation that needs to be performed by the second node in embodiments of this application.

Optionally, the communication apparatus may further include a storage module 1803, configured to store program code and data of the communication apparatus. The data may include but is not limited to original data, intermediate data, or the like.

The processing module 1801 may be a processor or a controller, for example, may be a CPU, a general-purpose processor, an application-specific integrated circuit (application-specific integrated circuit, ASIC), a field programmable gate array (field programmable gate array, FPGA) or another programmable logic device, a transistor logic device, a hardware component, or any combination thereof. The processing module may implement or execute various example logical blocks, modules, and circuits described with reference to content disclosed in this application. The processor may alternatively be a combination for implementing a computing function, for example, a combination including one or more microprocessors, or a combination of a DSP and a microprocessor.

The communication module 1802 may be a communication interface, a transceiver, a transceiver circuit, or the like. The communication interface is a general name. In a specific implementation, the communication interface may include a plurality of interfaces, for example, an interface between a base station and a terminal and/or another interface.

The storage module 1803 may be a memory.

When the processing module 1801 is a processor, the communication module 1802 is a communication interface, and the storage module 1803 is a memory, the communication apparatus in embodiments of this application may be as shown in FIG. 19.

Refer to FIG. 19. The communication apparatus includes a processor 1901 and a communication interface 1902. Optionally, the communication apparatus may further include a memory 1903. The memory 1903 may be independent of the processor 1901, and is coupled to the processor 1901 through an interface, or may be integrated with the processor 1901. Optionally, the communication apparatus may further include a bus 1904. The communication interface 1902, the processor 1901, and the memory 1903 may be connected to each other through the bus 1904. The bus 1904 may be a peripheral component interconnect (peripheral component interconnect, PCI) bus, an extended industry standard architecture (extended industry standard architecture, EISA) bus, or the like. The bus 1904 may be classified into an address bus, a data bus, a control bus, and the like. For ease of representation, only one thick line is used to represent the bus in FIG. 19, but this does not mean that there is only one bus or only one type of bus.

Optionally, an embodiment of this application further provides a computer program product including computer instructions. When the computer instructions are run on a computer, the computer is enabled to perform the method described in the foregoing embodiments.

Optionally, an embodiment of this application further provides a computer-readable storage medium. The computer-readable storage medium stores computer instructions. When the computer instructions are run on a computer, the computer is enabled to perform the method described in the foregoing embodiments.

Optionally, an embodiment of this application further provides a chip, including a processing circuit and an input/output interface. The processing circuit and the input/output interface are configured to implement the method described in the foregoing embodiments. The processing circuit is configured to perform a processing action in the corresponding method, and the input/output interface is configured to perform a receiving/sending action in the corresponding method.

Optionally, an embodiment of this application further provides a communication system, including the first node provided in the foregoing embodiments and the second node provided in the foregoing embodiments.

A person of ordinary skill in the art may understand that: All or some of the foregoing embodiments may be implemented by software, hardware, firmware, or any combination thereof. When software is used to implement the foregoing embodiments, all or some of embodiments may be implemented in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device like a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium (for example, a solid state disk (solid state disk, SSD)), or the like.

In the several embodiments provided in this application, it should be understood that the disclosed system, apparatus, and method may be implemented in other manners. For example, the described apparatus embodiment is merely an example. For example, division into the modules is merely logical function division and may be other division in actual implementation. For example, a plurality of modules or components may be combined or integrated into another system, or some features may be ignored or not performed. In addition, the displayed or discussed mutual couplings or direct couplings or communication connections may be implemented through some interfaces. The indirect couplings or communication connections between the apparatuses or modules may be implemented in electronic or other forms.

The units described as separate parts may or may not be physically separate, and parts displayed as units may or may not be physical units, may be located in one location, or may be distributed on a plurality of devices. Some or all of the units may be selected based on actual requirements to achieve the objectives of the solutions of embodiments.

Based on the foregoing descriptions of the implementations, a person skilled in the art may clearly understand that this application may be implemented by software in addition to necessary universal hardware or by hardware only. In most circumstances, the former is a better implementation. Based on such an understanding, the technical solutions of this application essentially or the part making contribution may be implemented in a form of a software product. The computer software product is stored in a readable storage medium like a floppy disk, a hard disk, or an optical disc of a computer, and includes several instructions for instructing a computer device (which may be a personal computer, a server, or a network device) to perform the methods described in embodiments of this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A channel state information CSI obtaining method, wherein the method comprises:
when a first node is in a sensing mode, receiving, by the first node, at least one first signal frame from a second node;
processing, by the first node, the at least one first signal frame based on a same automatic gain control AGC gain; and
obtaining, by the first node, CSI based on at least one processed first signal frame.

2. The method according to claim 1, wherein the method further comprises:
when the first node is in a non-sensing mode, receiving, by the first node, at least one second signal frame from the second node; and
processing, by the first node, the at least one second signal frame based on different AGC gains.

3. The method according to claim 1 or 2, wherein the method further comprises:
when a preset condition is met, updating, by the first node, a value of the used same AGC gain, wherein
the preset condition comprises one or more of the following:
preset duration;
a quantity of first signal frames received by the first node meets a first threshold;
a total quantity of first signal frames and second signal frames that are received by the first node meets a second threshold; and
the first node determines that a probability that an error occurs when the first signal frame is parsed is greater than a preset probability.

4. The method according to any one of claims 1 to 3, wherein before the receiving, by the first node, at least one first signal frame from a second node, the method further comprises:
when the first node is in the sensing mode, receiving, by the first node, at least one third signal frame from the second node; and
processing, by the first node, the at least one third signal frame based on different AGC gains.

5. The method according to any one of claims 2 to 4, wherein the value of the same AGC gain is determined based on values of the different AGC gains.

6. The method according to any one of claims 1 to 5, wherein the value of the same AGC gain corresponds to the second node.

7. The method according to any one of claims 1 to 6, wherein each of the at least one first signal frame comprises a first field and a second field; and
the processing, by the first node, the at least one first signal frame based on a same AGC gain comprises:
processing, by the first node, at least one first field based on the same AGC gain, and processing, by the first node, at least one second field based on the same AGC gain or different AGC gains, wherein CSI obtained based on the at least one first field is used by the first node to sense a target;
or
processing, by the first node, at least one first field based on the same AGC gain or different AGC gains, and processing, by the first node, at least one second field based on the same AGC gain, wherein CSI obtained based on the at least one second field is used by the first node to sense a target.

8. The method according to any one of claims 1 to 7, wherein before the receiving, by the first node, at least one first signal frame from a second node, the method further comprises:
receiving, by the first node, a first message, wherein the first message is generated based on a first operation; and
enabling, by the first node, the sensing mode in response to the first message.

9. The method according to any one of claims 1 to 8, wherein before the receiving, by the first node, at least one first signal frame from a second node, the method further comprises:
receiving, by the first node, a second message, wherein the second message is generated based on a second operation; and
determining, by the first node, the second node in response to the second message.

10. A CSI obtaining method, wherein the method comprises:
generating, by a second node, at least one first signal frame; and
sending, by the second node, the at least one first signal frame to a first node, wherein the at least one first signal frame is processed by the first node in a sensing mode based on a same AGC gain, to obtain CSI information.

11. The method according to claim 10, wherein the method further comprises:
generating, by the second node, at least one second signal frame; and
sending, by the second node, the at least one second signal frame to the first node, wherein the at least one second signal frame is processed by the first node in a non-sensing mode based on different AGC gains.

12. The method according to claim 10 or 11, wherein a value of the same AGC gain is updated when a preset condition is met; and
the preset condition comprises one or more of the following:
preset duration;
a quantity of first signal frames received by the first node meets a first threshold;
a total quantity of first signal frames and second signal frames that are received by the first node meets a second threshold; and
the first node determines that a probability that an error occurs when the first signal frame is parsed is greater than a preset probability.

13. The method according to any one of claims 10 to 12, wherein before the sending, by the second node, the at least one first signal frame to a first node, the method further comprises:
sending, by the second node, at least one third signal frame to the first node, wherein the at least one third signal frame is processed by the first node in the sensing mode based on different AGC gains.

14. The method according to any one of claims 11 to 13, wherein the value of the same AGC gain is determined based on values of the different AGC gains.

15. The method according to any one of claims 10 to 14, wherein the value of the same AGC gain corresponds to the second node.

16. The method according to any one of claims 10 to 15, wherein each of the at least one first signal frame comprises a first field and a second field; and
that the at least one first signal frame is processed by the first node in a sensing mode based on a same AGC gain is specifically:
at least one first field is processed by the first node in the sensing mode based on a same AGC gain, and at least one second field is processed by the first node in the sensing mode based on a same AGC gain or different AGC gains, wherein CSI obtained based on the at least one first field is used by the first node to sense a target;
or
at least one first field is processed by the first node in the sensing mode based on a same AGC gain or different AGC gains, and at least one second field is processed by the first node in the sensing mode based on a same AGC gain, wherein CSI obtained based on the at least one second field is used by the first node to sense a target.

17. A communication apparatus, wherein the communication apparatus comprises modules configured to perform steps in the method according to any one of claims 1 to 9, or the communication apparatus comprises modules configured to perform steps in the method according to any one of claims 10 to 16.

18. A communication apparatus, comprising a processor and a communication interface, wherein the communication interface is configured to communicate with another apparatus, and the processor is configured to perform the method according to any one of claims 1 to 9, or the processor is configured to perform the method according to any one of claims 10 to 16.

19. A computer-readable storage medium, comprising a computer program or instructions, wherein when the computer program or the instructions are run on a communication apparatus, the communication apparatus is enabled to perform the method according to any one of claims 1 to 9, or the communication apparatus is enabled to perform the method according to any one of claims 10 to 16.

20. A computer program product, wherein the computer program product comprises a computer program or instructions, and when the computer program or the instructions are run on a computer, the computer is enabled to perform the method according to any one of claims 1 to 9, or the computer is enabled to perform the method according to any one of claims 10 to 16.
